# EUROPEAN PATENT APPLICATION

(11) **EP 4 621 780 A1**
(43) Date of publication of application: **24.09.2025**
(21) Application number: 23891431.1
(22) Date of filing: 08.11.2023
(51) Int. Cl.: G11C 11/16

(54) **STORAGE DEVICE, ELECTRONIC APPARATUS, AND STORAGE DEVICE CONTROL METHOD**

(30) Priority: 17.11.2022 JP 2022184479
(71) Applicant: Sony Semiconductor Solutions Corporation, Atsugi-shi, Kanagawa 243-0014 (JP)
(72) Inventor: HIGO, Yutaka, Atsugi-shi, Kanagawa 243-0014 (JP); SAKAI, Lui, Atsugi-shi, Kanagawa 243-0014 (JP); HIRAGA, Keizo, Atsugi-shi, Kanagawa 243-0014 (JP); HOSOMI, Masanori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/040142
(87) International publication number: WO 2024/106279

(57) **Abstract**

A storage device according to one embodiment of the present disclosure includes a magnetoresistive element with a resistance state changing upon application of a voltage, a selection element connected to the magnetoresistive element, a control line connected to the side of the magnetoresistive element opposite to the side connected to the selection element, a voltage application unit connected to the control line to output a voltage to the magnetoresistive element, and a read unit connected to the control line to read the resistance state of the magnetoresistive element, the read unit reads the resistance state of the magnetoresistive element during an operation in which the voltage application unit outputs the voltage, and the voltage application unit controls the operation depending on the resistance state of the magnetoresistive element read by the read unit.

## Description

### Field

The present disclosure relates to a storage device, an electronic apparatus, and a method of controlling the storage device.

### Background

Magnetoresistive random-access memory (MRAM), which uses a magnetoresistive element as a storage element, is a type of non-volatile memory that retains recorded data even if the power is turned off, as it stores states depending on the magnetization state of ferromagnetic materials. The basic structure of a magnetoresistive element is a sandwich structure in which a non-magnetic insulating thin film is sandwiched between two magnetic layers formed from thin magnetic material. This structure is called a magnetic tunnel junction (MTJ). Since the thickness of the non-magnetic thin film is extremely thin, on the order of a few nanometers, applying a voltage across the two ends of the element causes a tunnel current to flow. A distinctive feature of this structure is that the magnitude of the tunnel current depends on the relative angle of magnetization between the two magnetic layers. This phenomenon is called a Tunnel Magneto Resistance (TMR) effect.

In MRAM, the magnetization of one of the two magnetic layers (the magnetization pinned layer) is fixed, while the magnetization of the other magnetic layer (the storage layer) is controlled by an external field. The state in which the magnetization of the magnetization pinned layer and the storage layer are parallel to each other is defined as state 0, and the state in which they are antiparallel is defined as state 1. In this way, the state ("0" or "1") is stored in a non-volatile manner by rewriting the parallel and antiparallel states of magnetization. The external field used to control the direction of magnetization includes a current magnetic field generated by passing a current through external wiring, a method of passing a current directly through the MTJ and using the spin-transfer torque (STT) effect, and a method of using voltage-controlled magnetic anisotropy (VCMA). The state is read using the TMR effect.

The currently mainstream MRAM is STT-MRAM, which allows for greater miniaturization and reduced power consumption, compared to using current-induced magnetic fields. On the other hand, voltage-controlled (VC) MRAM using VCMA is attracting attention for its highspeed writing capabilities and even lower power consumption for operation. The voltage writing method using VCMA, disclosed in Patent Literature 1, achieves bidirectional writing by applying an ultrafast pulse voltage with unipolarity (applying voltage in only one direction).

In the conventional voltage writing method, a bidirectional write operation is performed with a unipolar voltage. While no voltage is applied to the MTJ, the magnetization orientation of the storage layer is directed in the direction perpendicular to the film plane (z direction) due to the perpendicular magnetic anisotropy of the storage layer (the property that magnetization tends to be oriented perpendicularly to the film plane). Similarly, the magnetization orientation of the pinned layer is also directed in the z direction due to its perpendicular magnetic anisotropy. Now, it is assumed that the magnetization of both the storage layer and the pinned layer is in the +z direction, that is, in a parallel state, and the state 0 is written. Additionally, it is assumed that an external magnetic field is applied in the +x direction of the film in-plane directions (x direction and y direction). In this context, if a voltage is applied to the MTJ, the electric field generated near the interface between the non-magnetic layer and the storage layer causes the perpendicular magnetic anisotropy of the storage layer to disappear, which results in the loss of the property that the magnetization tends to be oriented in the perpendicular direction to the film plane. As a result, the magnetization of the storage layer begins to move toward the x direction where the magnetic energy is minimized due to the external magnetic field, but it does not simply change in a straight line from the +z direction to the +x direction; instead, a so-called precessional motion begins, with the magnetization gradually moving towards the +x direction while rotating in the yz plane. During the precessional motion in the yz plane, the magnetization of the storage layer, initially orienting in the +z direction, has a moment where it orients in the approximately -z direction. At this event, setting the voltage applied to the MTJ to zero causes the perpendicular magnetic anisotropy of the storage layer to return to its original state, making it easier for the magnetization to orient in the perpendicular direction to the film plane, which results in the magnetization of the storage layer being fixed in the -z direction. In other words, by applying a pulsed voltage, the magnetizations of the storage layer and the pinned layer are written from the state 0, in which the magnetizations are parallel, to the state 1, in which the magnetizations are antiparallel. A similar process occurs with the state 1, in which the magnetization of the storage layer is initially oriented in the -z direction, so bidirectional writing can be implemented with the application of a unipolar pulsed voltage.

However, in the above-mentioned writing method, for example, in writing the state 1 from the state 0, it was necessary to set the voltage applied to the MTJ to zero at the moment when the magnetization of the storage layer was oriented approximately in the - z direction during its precessional motion in the yz plane. In other words, the pulse width of the pulsed write voltage needs to be controlled with high precision. Thus, the self-adaptive writing method disclosed in Non-Patent Literature 1 involves monitoring the voltage applied to the MTJ during write operation, and automatically setting the voltage to zero once the desired state is written, i.e., performing a so-called self-adaptive write operation. This eliminates the need to control the pulse width of the pulsed write voltage with high precision.

### Citation List

### Patent Literature

Patent Literature 1: JP 2018-092696 A

### Non Patent Literature

Non Patent Literature 1: M. Long et al, "Self-Adaptive Write Circuit for Magnetic Tunneling Junction Memory With Voltage-Controlled Magnetic Anisotropy Effect", IEEE Transactions on Nanotechnology, vol. 17, no. 3, pp. 492-499, 2018

### Summary

### Technical Problem

In the above self-adaptive writing method, a wiring connected between the MTJ and the cell selection transistor is used to monitor the voltage applied to the MTJ during the write operation. However, this memory cell structure requires a separate wiring to monitor each memory cell, which leads to an increase in the memory cell area. For example, Non-Patent Literature 1 discloses that the memory cell area of the self-adaptive writing method disclosed in Non-Patent Literature 1 is approximately 20 times larger than that of a normal memory cell.

In addition, another issue with the above-mentioned self-adaptive writing method is that, depending on whether the initial state before writing is the state 0 or state 1, the voltage applied to the MTJ at the start of writing differs from the desired voltage in either or both states due to the influence of the wiring for monitoring (e.g., the influence of the monitoring circuit). In the voltage writing method using VCMA, it is desirable that the voltage applied to the MTJ at the start of writing is equal to the voltage that eliminates the perpendicular magnetic anisotropy of the storage layer. In this case, the precessional motion achieves an ideal form. In Non-Patent Literature 1, the fact that the voltage applied to the MTJ at the start of writing differs from the desired voltage depending on whether the initial state before writing is the state 0 or state 1 means that the voltage applied to the MTJ at the start of writing in either or both states is different from the voltage that eliminates the perpendicular magnetic anisotropy of the storage layer. This makes the precessional motion non-ideal, resulting in instability in the write operation. One possible undesirable result may be a failure of the write operation.

Thus, the present disclosure provides a storage device, an electronic apparatus, and a method of controlling the storage device, capable of implementing a self-adaptive writing method while minimizing the memory cell area and improving the stability of the write operation.

### Solution to Problem

A storage device according to one embodiment of the present disclosure includes: a magnetoresistive element with a resistance state changing upon application of a voltage; a selection element connected to the magnetoresistive element; a control line connected to a side of the magnetoresistive element opposite to a side connected to the selection element; a voltage application unit connected to the control line to output a voltage to the magnetoresistive element; and a read unit connected to the control line to read the resistance state of the magnetoresistive element, wherein the read unit reads the resistance state of the magnetoresistive element during an operation in which the voltage application unit outputs the voltage to the magnetoresistive element, and the voltage application unit controls the operation depending on the resistance state of the magnetoresistive element read by the read unit.

An electronic apparatus according to one embodiment of the present disclosure includes: a storage device configured to store data, wherein the storage device includes: a magnetoresistive element with a resistance state changing upon application of a voltage; a selection element connected to the magnetoresistive element; a control line connected to a side of the magnetoresistive element opposite to a side connected to the selection element; a voltage application unit connected to the control line to output a voltage to the magnetoresistive element; and a read unit connected to the control line to read the resistance state of the magnetoresistive element, the read unit reads the resistance state of the magnetoresistive element during an operation in which the voltage application unit outputs the voltage to the magnetoresistive element, and the voltage application unit controls the operation depending on the resistance state of the magnetoresistive element read by the read unit.

A method of controlling a storage device according to one embodiment of the present disclosure, the method includes: outputting a voltage to a magnetoresistive element by a voltage application unit connected to a control line, in a memory cell including the magnetoresistive element with a resistance state changing upon application of a voltage and a selection element connected to the magnetoresistive element, the control line being connected to a side of the magnetoresistive element opposite to a side connected to the selection element; and reading the resistance state of the magnetoresistive element by a read unit connected to the control line, wherein the read unit reads the resistance state of the magnetoresistive element during an operation in which the voltage application unit outputs the voltage to the magnetoresistive element, and the voltage application unit controls the operation depending on the resistance state of the magnetoresistive element read by the read unit.

### Brief Description of Drawings

FIG. 1 is a diagram illustrating a first configuration example of a memory system according to an embodiment of the present disclosure.
FIG. 2 is a diagram illustrating a second configuration example of the memory system according to an embodiment of the present disclosure.
FIG. 3 is a diagram illustrating a first configuration example of a memory cell according to an embodiment of the present disclosure.
FIG. 4 is a diagram illustrating a second configuration example of the memory cell according to an embodiment of the present disclosure.
FIG. 5 is a diagram illustrating a first configuration example of a magnetoresistive element according to an embodiment of the present disclosure.
FIG. 6 is a diagram illustrating a second configuration example of the magnetoresistive element according to an embodiment of the present disclosure.
FIG. 7 is a diagram schematically illustrating a write unit according to an embodiment of the present disclosure.
FIG. 8 is a circuit diagram illustrating a first configuration example of the write unit according to an embodiment of the present disclosure.
FIG. 9 is a circuit diagram illustrating a first configuration example of a read unit according to an embodiment of the present disclosure.
FIG. 10 is a circuit diagram illustrating a second configuration example of the read unit according to an embodiment of the present disclosure.
FIG. 11 is a circuit diagram illustrating a first configuration example of a reference voltage generation unit according to an embodiment of the present disclosure.
FIG. 12 is a circuit diagram illustrating a second configuration example of the reference voltage generation unit according to an embodiment of the present disclosure.
FIG. 13 is a circuit diagram illustrating a configuration example of a reference resistor according to an embodiment of the present disclosure.
FIG. 14 is a circuit diagram illustrating a configuration example of a voltage application unit and a memory cell according to an embodiment of the present disclosure.
FIG. 15 is a diagram illustrated to describe a first example of a simulation result according to an embodiment of the present disclosure.
FIG. 16 is a diagram illustrated to describe a second configuration example of the simulation result according to an embodiment of the present disclosure.
FIG. 17 is a circuit diagram illustrating a second configuration example of the write unit according to an embodiment of the present disclosure.
FIG. 18 is a circuit diagram illustrating a third configuration example of the write unit according to an embodiment of the present disclosure.
FIG. 19 is a circuit diagram illustrating configuration examples of a write voltage generation unit, a voltage application unit, and a memory cell according to an embodiment of the present disclosure.
FIG. 20 is a diagram illustrated to describe a third example of the simulation result according to an embodiment of the present disclosure.
FIG. 21 is a diagram illustrated to describe a load resistor based on the third example of a simulation result according to an embodiment of the present disclosure.
FIG. 22 is a diagram illustrated to describe a fourth example of the simulation result according to an embodiment of the present disclosure.
FIG. 23 is a diagram illustrating an example of a schematic configuration of an imaging device.
FIG. 24 is a diagram illustrating an example of the general configuration of a distance measurement device.
FIG. 25 is a diagram illustrating an example of an external appearance of a gaming device.
FIG. 26 is a diagram illustrating an example of a general configuration of a gaming device.

### Description of Embodiments

The following describes in detail the embodiments of the present disclosure with reference to the drawings. The embodiments include examples and modifications. Moreover, the embodiments do not limit the devices, apparatuses, methods, or the like of the present disclosure. Additionally, in the following embodiments, the same reference numerals will be assigned to the same parts, and redundant descriptions will be omitted.

The following one or more embodiments can each be implemented independently. On the other hand, at least a part of the following multiple embodiments may be implemented in appropriate combination with at least a part of other embodiments. These multiple embodiments may include novel features different from each other. Thus, each embodiment may contribute to solving different objectives or issues and may produce different effects. Moreover, the effects of each embodiment are merely illustrative and are not construed as limiting, and other effects may also be possible.

In addition, the drawings referred to in the following description are provided to describe an embodiment of the present disclosure and to facilitate understanding of the same, and for ease of understanding, the shapes, dimensions, ratios, or the like illustrated in the drawings may differ from the actual ones. Furthermore, the elements and the like illustrated in the drawings can be appropriately modified in design by taking into consideration the following description and known techniques. Additionally, in the following description, the up-down direction of the stacked structure of the elements and the like corresponds to the relative direction in the case where the surface of the substrate on which the elements are provided is considered to be up, and this direction may differ from the up-down direction according to the actual gravitational acceleration.

Moreover, in describing the magnetization direction (magnetic moment) and magnetic anisotropy, terms such as "perpendicular direction" (the direction perpendicular to the film surface or the stacking direction of the stacked structure) and "in-plane direction" (direction parallel to the film surface or direction perpendicular to the stacking direction of the stacked structure) may be used for convenience. However, these terms do not necessarily indicate the exact direction of magnetization. For example, the expressions such as "magnetization direction is perpendicular" and "having perpendicular magnetic anisotropy" mean that the magnetization in the perpendicular direction is dominant compared to the magnetization in the in-plane direction. Similarly, for example, the expressions such as "magnetization direction is in-plane" and "has in-plane magnetic anisotropy" mean that the magnetization in the in-plane direction is dominant compared to the perpendicular magnetization.

In this context, the present inventors have developed a compact model in the Verilog-A language of an MTJ with VCMA effects that can be incorporated into a simulation program with integrated circuit emphasis (SPICE) simulator, and as a result of research using a SPICE simulation with the MTJ model, they invented a non-toggle-type writing method. In the non-toggle-type writing method disclosed herein, for example, in a memory cell in which a cell transistor and an MTJ are connected in series, voltages of different magnitudes are applied to the memory cell in the case of a writing state 1 and a writing state 0. In this case, the voltage applied to the memory cell is divided between the cell transistor and the MTJ, but the voltage applied to the MTJ changes depending on the state already written in the MTJ. As a result, in the case where the state 1 is already written and the state 1 needs to be written and the case where the state 0 is already written and the state 0 needs to be written, it is possible to prevent erroneous writing from occurring. Thus, the toggle-type writing method of the prior art required reading the initial state before writing, whereas the non-toggle-type writing method of the present disclosure eliminates the need to read the initial state before writing. Thus, it is possible to reduce the reading time and power consumption required in the initial reading. The non-toggle-type writing method of the present disclosure will be described in detail later.

The present disclosure is now described in accordance with the order of items illustrated below.
1. Embodiments
1-1. Configuration example of memory system
1-2. Configuration example of memory cell
1-3. Configuration example of magnetoresistive element
1-4. First configuration example of write unit
1-5. Simulation results
1-6. Second configuration example of write unit
1-7. Simulation results
1-8. Operation and effects
2. Other embodiments
3. Configuration example of electronic apparatus
3-1. Imaging device
3-2. Distance measurement device
3-3. Game device
4. Supplementary notes

### <1. Embodiments>

### <1-1. Configuration example of memory system>

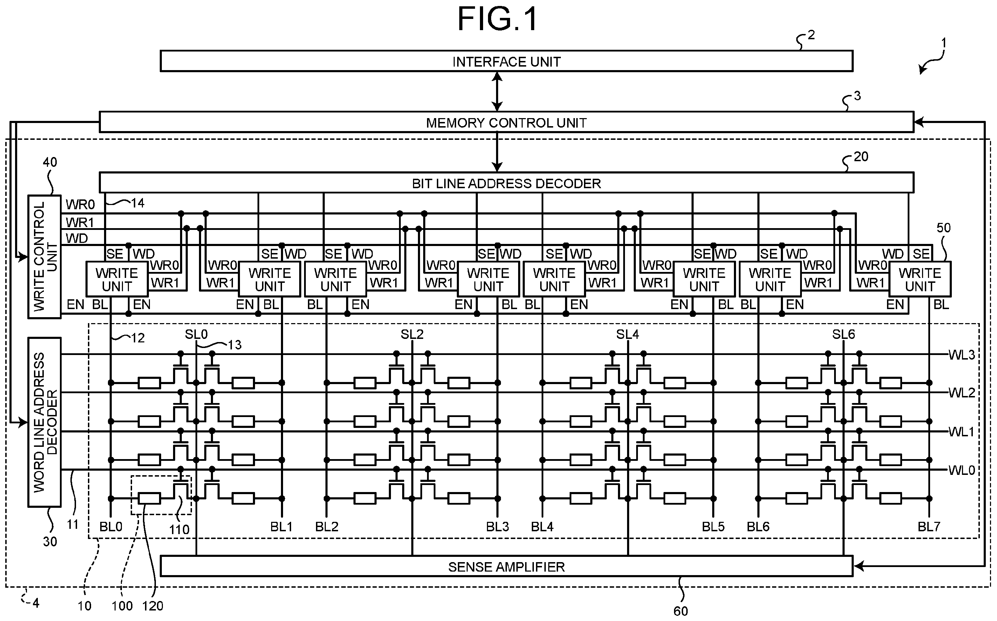

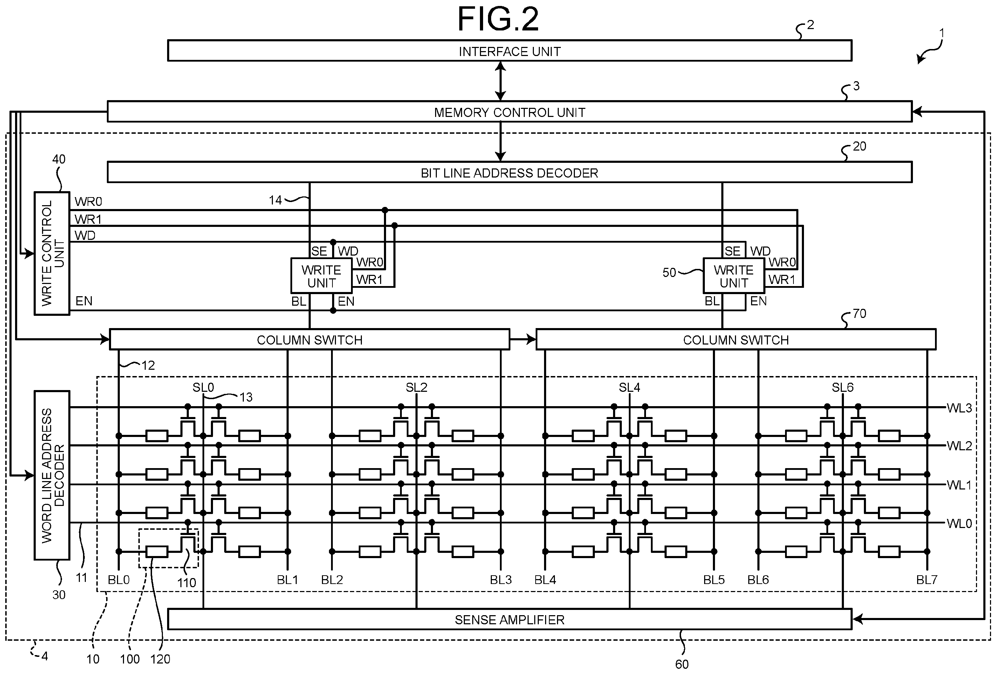

A configuration example of a memory system 1 according to the present embodiment is now described with reference to FIGS. 1 and 2.

FIG. 1 is a diagram illustrating the configuration example of the memory system 1 according to the present embodiment. This memory system 1 is an example of a storage device that retains information based on the magnetization direction of a magnetic material.

As illustrated in FIG. 1, the memory system 1 according to the present embodiment includes an interface unit 2, a memory control unit 3, and a memory array 4.

The interface unit 2 performs signal exchange (e.g., transmission and reception) with a host system or the like not illustrated using the memory system 1.

The memory control unit 3 communicates with the host system or the like via the interface unit 2 and controls the memory array 4. This memory control unit 3 receives a command from the host system and controls data writing and reading based on the received command. For example, the memory control unit 3 outputs a write and read command or an address to the memory array 4. In the case of the write command, the writing target data is also output at the same time. Additionally, the memory control unit 3 outputs a read command and then receives read data from the memory array 4.

The memory array 4 is used to store data. This memory array 4 includes a memory cell array 10, a bit line address decoder 20, a word line address decoder 30, a write control unit 40, a write unit 50, and a sense amplifier 60.

The memory cell array 10 is configured with memory cells 100 that store data and are arranged in a two-dimensional matrix. This memory cell 100 includes a selection element 110 and a magnetoresistive element 120. For the magnetoresistive element 120, a magnetoresistive element such as an MTJ can be used. The selection element 110 is an element that is connected to one end of the magnetoresistive element 120 and controls the application of a voltage to the magnetoresistive element 120. For the selection element 110, for example, an n-channel MOS transistor can be used.

The memory cell 100 is connected to a word line 11 (WL) and a bit line 12 (BL), which transmit a control signal. Additionally, in the memory cell 100, a source line 13 (SL) is further arranged to transmit a signal from the magnetoresistive element 120. In the memory cell array 10, a plurality of word lines 11 is wired to extend in the row direction, and a plurality of bit lines 12 and a plurality of source lines 13 are wired to extend in the column direction. The respective word lines 11, bit lines 12, and source lines 13 function as a control line.

Moreover, in the memory cell array 10, the source line 13 is shared by two memory cells 100 adjacent in the row direction. By doing so, it is possible to reduce the area of the memory cell array 10. However, it is also possible to configure two adjacent memory cells 100 in the row direction not to share the source line 13 but to be connected to a separate source line 13.

The bit line address decoder 20 selects a write selection line 14 (SE) connected to the write unit 50 based on a control signal from the memory control unit 3, and outputs a control signal to the selected write selection line 14.

The word line address decoder 30 selects the word line 11 of the memory cell array 10 based on the control signal from the memory control unit 3, and outputs a control signal to the selected word line 11.

The write control unit 40 outputs a control signal to the write unit 50 based on the control signal from the memory control unit 3.

The write unit 50 outputs a control signal to the bit line 12 based on a control signal from the write control unit 40 and a control signal from the bit line address decoder 20. The write unit 50 performs writing to the magnetoresistive element 120 for the memory cell 100 at the intersection of the selected word line 11 and bit line 12 via the selection element 110 of the memory cell 100.

The sense amplifier 60 detects the current flowing through the memory cell 100 during the read operation to read data. The sense amplifier 60 reads the magnetoresistive element 120 of the memory cell 100 at the intersection of the selected word line 11 and bit line 12 via the selection element 110 of the memory cell 100.

The reading from the memory cell 100 can be performed by applying a predetermined read voltage to the magnetoresistive element 120 of the memory cell 100 and detecting the current flowing through the memory cell 100. The read voltage preferably has a different polarity from the write voltage. Moreover, details regarding the writing to the memory cell 100 will be described later.

Another configuration example of the memory system 1 according to the embodiment is now described with reference to FIG. 2. FIG. 2 is a diagram illustrating another configuration example of the memory system 1 according to the embodiment of the present disclosure. This memory system 1 is also an example of a storage device that retains information depending on the magnetization direction of a magnetic material.

As illustrated in FIG. 2, unlike FIG. 1, a column switch 70 is arranged between the memory cell array 10 and the write unit 50. In the example of FIG. 2, one column switch 70 is arranged for each of four bit lines 12 of the memory cell array 10, but the number of bit lines 12 of the memory cell array 10 connected to one column switch 70 can be set to any value. If n is an integer equal to or greater than 1, it is preferable to connect two to the power of n bit lines 12 of the memory cell array 10 to one column switch 70. Then, unlike FIG. 1, the memory control unit 3 outputs a part of the bit line addresses received from the interface unit 2 to the column switch 70, and outputs the remaining bit line addresses to the bit line address decoder 20.

The column switch 70 connects the bit line 12 of the write unit 50 to one of the bit lines 12 of the memory cell array 10 connected to the column switch 70, based on the control signal from the memory control unit 3. In FIG. 1, the write unit 50 is connected to all of the bit lines 12 of the memory cell array 10, but in FIG. 2, the write unit 50 is connected to all of the column switches 70. In this way, the number of write units 50 can be reduced in the configuration example of FIG. 2. Other functions are similar to those of the memory system 1 illustrated in FIG. 1.

### <1-2. Configuration example of memory cell>

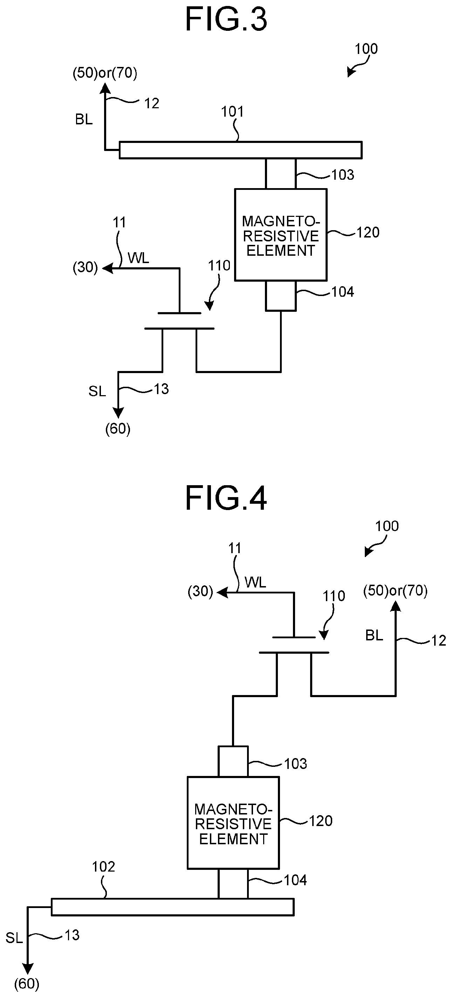

A configuration example of the memory cell 100 according to the present embodiment is now described with reference to FIGS. 3 and 4. FIGS. 3 and 4 are diagrams illustrating the respective configuration examples of the memory cell 100 according to the present embodiment. Each figure is a schematic diagram illustrating the configuration example of the memory cell 100. Moreover, as described previously, the memory cell 100 includes a selection element 110 and a magnetoresistive element 120. In the examples of FIG. 3 and FIG. 4, the selection element 110 and the magnetoresistive element 120 are connected in series, and the selection element 110 has a drain (drain terminal), a source (source terminal), and a gate (gate terminal).

As illustrated in FIG. 3, the magnetoresistive element 120 of the memory cell 100 is connected to a wiring 101 via a contact layer 103 and to the selection element 110 via a contact layer 104. The drain of the selection element 110 is connected to the contact layer 104, and the source is connected to the source line 13 (SL). Additionally, the gate of the selection element 110 is connected to the word line 11 (WL). Moreover, the contact layer 103 is connected to the wiring 101 that constitutes the bit line 12 (BL). By applying an on voltage to the word line 11 (WL), the selection element 110 becomes conductive, enabling the application of a voltage to the magnetoresistive element 120.

As illustrated in FIG. 4, the magnetoresistive element 120 of the memory cell 100 is connected to a wiring 102 via the contact layer 104 and to the selection element 110 via the contact layer 103. The drain of the selection element 110 is connected to the bit line 12 (BL) and the source is connected to the contact layer 103. Additionally, the gate of the selection element 110 is connected to the word line 11 (WL). Moreover, the contact layer 104 is connected to the wiring 102 that constitutes the source line 13 (SL). By applying an on voltage to the word line 11 (WL), the selection element 110 becomes conductive, enabling the application of a voltage to the magnetoresistive element 120.

As described previously, the word line 11 (WL) is connected to the word line address decoder 30 (see FIG. 1 or 2). The bit line 12 (BL) is connected to the write unit 50 (see FIG. 1) or the column switch 70 (see FIG. 2). The source line 13 (SL) is connected to the sense amplifier 60 (see FIG. 1 or 2). By applying a voltage between the bit line 12 (BL) and the source line 13 (SL) and also applying an on voltage to the word line 11 (WL) to make the selection element 110 conductive, it is possible to apply a voltage used for writing or reading to the magnetoresistive element 120.

### <1-3. Configuration example of magnetoresistive element>

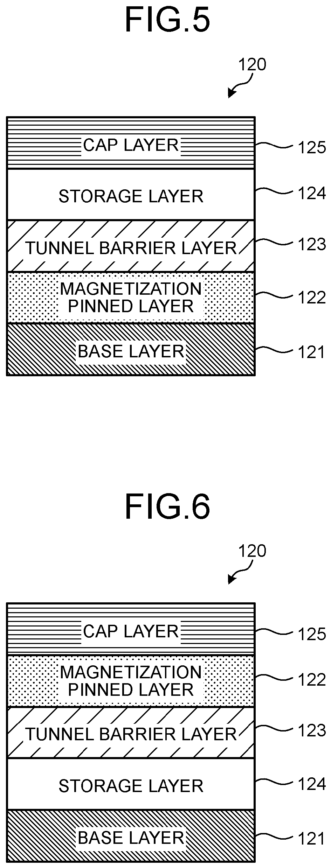

A configuration example of the magnetoresistive element 120 according to the present embodiment is now described with reference to FIGS. 5 and 6. FIGS. 5 and 6 are diagrams illustrating the respective configuration examples of the magnetoresistive element 120 according to the present embodiment. Each figure is a cross-sectional view illustrating the configuration example of the magnetoresistive element 120.

As illustrated in FIGS. 5 and 6, the magnetoresistive element 120 includes a base layer 121, a magnetization pinned layer 122, a tunnel barrier layer 123, a storage layer 124, and a cap layer 125. The magnetoresistive element 120 illustrated in FIG. 5 is configured by stacking the base layer 121, the magnetization pinned layer 122, the tunnel barrier layer 123, the storage layer 124, and the cap layer 125 in this order. On the other hand, the magnetoresistive element 120 illustrated in FIG. 6 is configured by stacking the base layer 121, the storage layer 124, the tunnel barrier layer 123, the magnetization pinned layer 122, and the cap layer 125 in this order.

The base layer 121 can be, for example, a layer formed from a noble metal or transition metal element such as Cr, Ta, Ru, Au, Ag, Cu, Al, Ti, V, Mo, Zr, Hf, Re, W, Pt, Pd, Ir, and Rh, or a stacked structure thereof. Additionally, the base layer 121 can also be formed from a conductive nitride such as TiN. For example, the base layer 121 is formed from a film used for controlling the crystal orientation of the magnetization pinned layer 122 and for improving the adhesion strength to the lower electrode.

The magnetization pinned layer 122 has magnetic anisotropy and is a layer where the magnetization direction is invariable. This magnetization pinned layer 122 can be formed from, for example, CoFeB, CoFeC alloy, NiFeB alloy, NiFeC alloy, or the like. In addition, the magnetization pinned layer 122 can also have a stacked ferromagnetic pinned structure in which multiple ferromagnetic layers are stacked with a non-magnetic layer interposed therebetween. As for the ferromagnetic layer that constitutes the magnetization pinned layer of this stacked ferromagnetic pinned structure, materials such as Co, CoFe, CoFeB, or the like can be used. Additionally, as for the non-magnetic layer, materials such as Ru, Re, Ir, Os, or the like can be used.

Furthermore, the magnetization pinned layer 122 can also be constructed in such a way that its magnetization direction is fixed by utilizing the antiferromagnetic coupling between the antiferromagnetic layer and the ferromagnetic layer. Examples of materials for the antiferromagnetic layer include magnetic materials such as FeMn alloy, PtMn alloy, PtCrMn alloy, NiMn alloy, IrMn alloy, NiO, Fe2O3, and the like. Additionally, non-magnetic elements such as Ag, Cu, Au, Al, Si, Bi, Ta, B, C, O, N, Pd, Pt, Zr, Hf, Ir, W, Mo, Nb, or the like can also be added to these magnetic materials.

The tunnel barrier layer 123 is arranged adjacent to the storage layer 124, which will be described later, and is used to apply an electric field to the storage layer 124 to impart a voltage-controlled magnetic anisotropy effect. The tunnel barrier layer 123 can be formed from an oxide of at least one element selected from the group of Mg, Al, Ti, Si, Zn, Zr, Hf, Ta, Bi, Cr, Ga, La, Gd, Sr, and Ba, or a nitride of at least one element selected from the group of Mg, Al, Ti, Si, Zn, Zr, Hf, Ta, Bi, Cr, Ga, La, Gd, Sr, and Ba. In addition, it can also be formed from an insulator, dielectric material, or semiconductors such as MgF2, CaF, SrTiO2, AlLaO3, AlNO, or the like. It can also have a structure in which these layers are stacked. Moreover, the thickness of the tunnel barrier layer 123 is preferably 0.6 nm or more.

The storage layer 124 has magnetic anisotropy and is a layer where the magnetization direction is variable. Additionally, the storage layer 124 is also a layer that has the VCMA effect. The state in which the magnetization direction of the storage layer 124 is the same as the magnetization direction of the magnetization pinned layer 122 and the state in which the magnetization direction of the storage layer 124 is different from the magnetization direction of the magnetization pinned layer 122 are referred to as the parallel state and the antiparallel state, respectively. The magnetoresistive element 120 assumes a low-resistance state in the parallel state and a high-resistance state in the antiparallel state. As described previously, applying a voltage to the magnetoresistive element 120 enables the magnetization direction of the storage layer 124 to be changed. For example, the low-resistance state is defined as the state 0, and the high-resistance state is defined as the state 1.

The storage layer 124 can also be formed from materials such as cobalt iron (CoFe), cobalt iron boron (CoFeB), Fe, iron boride (FeB), or the like. In addition, it is also possible to employ a configuration that includes transition metals (Hf, Ta, W, Re, Ir, Pt, Au, Zr, Nb, Mo, Ru, Rh, Pd, Ag, Ti, V, Cr, Mn, Ni, Cu) or the like. Additionally, it may also contain nitrides or oxides. Additionally, materials such as iridium (Ir) or osmium (Os) can be used to induce a proximity magnetic moment in a magnetic material. Moreover, the addition of heavy metals to the storage layer 124 can enhance the voltage-controlled magnetic anisotropy effect. It is preferable that the thickness of the storage layer 124 is 3.0 nm or less.

Furthermore, the storage layer 124 may also have a stacked structure in which multiple ferromagnetic layers are stacked with a non-magnetic layer interposed therebetween. In this case, two adjacent ferromagnetic layers may be exchange-coupled with each other via the non-magnetic layer. This non-magnetic layer can be formed from Mg, Al, Ti, Si, Zn, Zr, Hf, Ta, Bi, Cr, Ga, La, Gd, Sr, Ba, W, Re, Ir, Pt, Au, Nb, Mo, Ru, Rh, Pd, Ag, V, Mn, Ni, Cu, or the like.

The cap layer 125 is a layer that prevents metal diffusion from the wiring member. This cap layer 125 can be formed from metals such as Cr, Ta, Ru, Au, Ag, Cu, Al, Ti, V, Mo, Zr, Hf, Re, W, Pt, Pd, Ir, Rh, and others. Additionally, the cap layer 125 can also be formed from alloys containing these metals and from layers constituted by transition metal elements. In addition, the cap layer 125 can also be constituted by stacking these layers. Additionally, the cap layer 125 can also be formed from conductive nitrides such as TiN.

The various layers described previously can be produced, for example, using a physical vapor deposition (PVD) technique such as sputtering, ion beam deposition or using vacuum evaporation, or a chemical vapor deposition (CVD) technique such as atomic layer deposition (ALD). Additionally, these layers can be patterned using a reactive ion etching (RIE) or ion milling technique. It is preferable to form these various layers continuously in a vacuum apparatus and then perform patterning subsequently.

### <1-4. First configuration example of write unit>

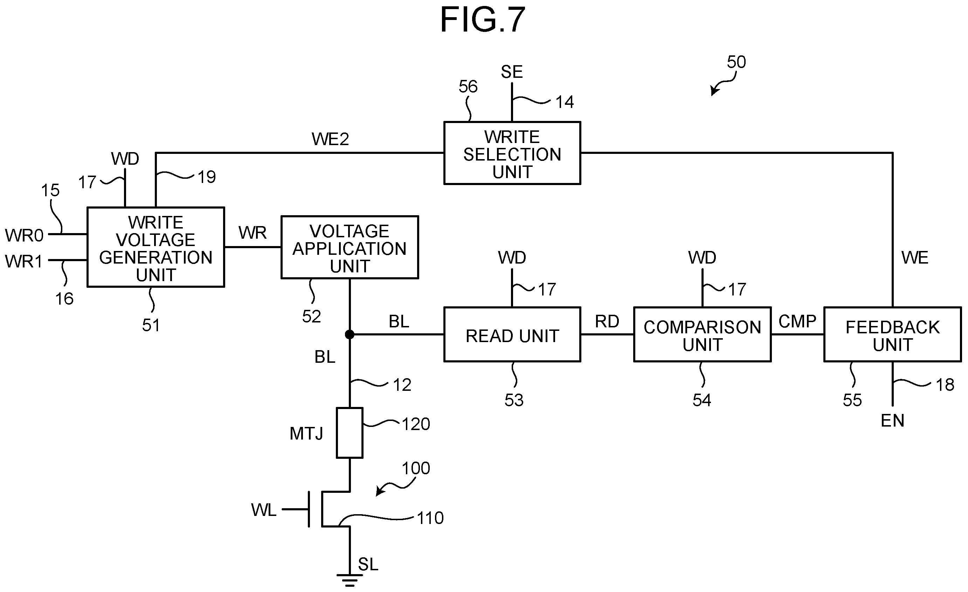

A first configuration example of the write unit 50 according to the present embodiment is now described with reference to FIGS. 7 to 13.

FIG. 7 is a schematic diagram of the write unit 50. As illustrated in FIG. 7, the write unit 50 includes a write voltage generation unit 51, a voltage application unit 52, a read unit 53, a comparison unit 54, a feedback unit 55, and a write selection unit 56.

The write voltage generation unit 51 has, as input terminals, a state-0 write voltage line 15 (WR0), a state-1 write voltage line 16 (WR1), a write data line 17 (WD), and a write signal line 19 (WE2). The state-0 write voltage line 15, the state-1 write voltage line 16, and the write data line 17 are connected to the write control unit 40. The write signal line 19 is connected to the write selection unit 56.

Under the control by the write control unit 40, a voltage for writing the state 0 is applied to the state-0 write voltage line 15, and a voltage for writing the state 1 is applied to the state-1 write voltage line 16. These voltages (voltage values) are denoted as V_{WR0} and V_{WR1,} respectively. The voltages V_{WR0} and V_{WR1} have different values. Additionally, under the control by the write control unit 40, an off voltage is applied to the write data line 17 in the case of writing the state 0, and an on voltage is applied to the write data line 17 in the case of writing the state 1.

The off voltage is a voltage that, in the case of being applied to the gate voltage of an n-channel MOS transistor, causes the drain terminal and the source terminal of the n-channel MOS transistor to become non-conductive, and can be, for example, a ground voltage. Additionally, the on voltage is a voltage that, in the case of being applied to the gate voltage of an n-channel MOS transistor, causes the drain terminal and the source terminal of the n-channel MOS transistor to become conductive, and can be, for example, a power supply voltage. The voltage of the write data line 17 is denoted as V_{WD}.

The write voltage generation unit 51 outputs either the voltage V_{WR0} of the state-0 write voltage line 15 or the voltage V_{WR1} of the state-1 write voltage line 16 to the voltage application unit 52 depending on the voltage V_{WD}. Specifically, the write voltage generation unit 51 outputs the voltage V_{WR0} in the case where the voltage V_{WD} is an off voltage, and outputs the voltage V_{WR1} in the case where the voltage V_{WD} is an on voltage. However, if the voltage of the write signal line 19 (a write selection voltage indicating whether or not a write operation is to be performed) is an off voltage (a voltage indicating that no writing is to be performed), the write voltage generation unit 51 outputs either the off voltage or the on voltage to the voltage application unit 52, independent of the value of the voltage V_{WD}. The voltage of the write signal line 19 is denoted as V_{WE2}.

The voltage application unit 52 outputs a voltage, which depends on the voltage output from the write voltage generation unit 51, to the bit line 12. The voltage output from the write voltage generation unit 51 is denoted as V_{WR}, and the voltage of the bit line 12 is denoted as V_{BL}. The voltage application unit 52 outputs the voltage V_{BL} to the read unit 53. Moreover, the memory cell 100 is connected to the bit line 12 (see FIG. 1).

The read unit 53 refers to the voltage V_{BL} output from the voltage application unit 52 and reads the state of the magnetoresistive element 120 of the memory cell 100 targeted for writing (e.g., state 0 or state 1). The read unit 53 has the write data line 17 as another input terminal. To read the state of the magnetoresistive element 120, the read unit 53 can use the voltage V_{WD}. The read unit 53 outputs the read data, i.e., a read voltage corresponding to the read data, to the comparison unit 54. This voltage is denoted as V_{RD}. The voltage V_{RD} is an off voltage in the case where the state of the magnetoresistive element 120 is the state 0, and an on voltage in the case where the state is the state 1.

The comparison unit 54 refers to the voltage V_{RD} output from the read unit 53 and compares the read data (e.g., the read state of the magnetoresistive element 120) with the write data (e.g., the target state of the magnetoresistive element 120). The comparison unit 54 has the write data line 17 as another input terminal. To perform the comparison, the comparison unit 54 can use the voltage V_{WD}. The comparison unit 54 outputs a comparison voltage corresponding to a comparison result to the feedback unit 55. This voltage is denoted as V_{CMP}. The voltage V_{CMP} is an on voltage in the case where the read data and the write data are equal, and an off voltage in the case where they differ. Alternatively, the voltage V_{CMP} may be an off voltage in the case where the read data and the write data are equal, and an on voltage in the case where they differ.

The read data indicates that the magnetoresistive element 120 is in the state 0 or the state 1, while the write data specifies that the magnetoresistive element 120 is in the state 0 or the state 1. If the read data and the write data are the same, it indicates that the state of the magnetoresistive element 120 is the same, and if the read data and the write data differ, it indicates that the state of the magnetoresistive element 120 is different.

The feedback unit 55 refers to the voltage V_{CMP} output from the comparison unit 54 to determine whether to continue or stop the writing. The feedback unit 55 has a write start signal line 18 (EN) as another input terminal. To determine whether to continue or stop the writing, the feedback unit 55 can use the voltage on the write start signal line 18. This voltage is denoted as V_{EN}. The voltage V_{EN} is an on voltage at the start of the writing, and an off voltage at other times. The feedback unit 55 refers to the voltage V_{CMP} and the voltage V_{EN} and outputs a write continuation signal to the write selection unit 56. This voltage is denoted as V_{WE}. The voltage V_{WE} is an on voltage in the case where the writing is continued, and an off voltage in the case where the writing is stopped.

The write selection unit 56 refers to the voltage V_{WE} output from the feedback unit 55 to select whether to continue or stop the writing. The write selection unit 56 has the write selection line 14 (SE) as another input terminal. To select whether to continue or stop the writing, the write selection unit 56 can use the voltage on the write selection line 14. This voltage is denoted as V_{SE}. The voltage V_{SE} is an on voltage in the case where the writing is performed, and an off voltage in the case where the writing is not performed. If the voltage V_{SE} is an on voltage, the write selection unit 56 outputs the voltage V_{WE} without any changes to the write voltage generation unit 51, and if the voltage V_{SE} is an off voltage, it outputs an off voltage to the write voltage generation unit 51. As described earlier, this voltage is denoted as V_{WE2}.

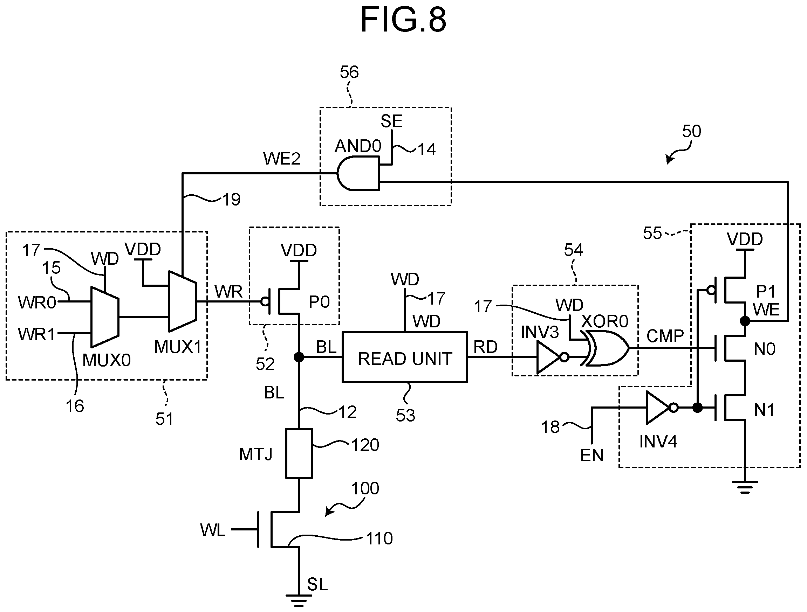

FIG. 8 illustrates a more detailed circuit diagram of the write unit 50 illustrated in FIG. 7. However, FIG. 8 is merely one example of the form of the write unit 50, and the write unit 50 is not limited to this form. Moreover, the operation of the circuit diagram illustrated in FIG. 8 can be easily understood by comparing it with the description of FIG. 7 mentioned previously, but some additional descriptions are provided.

The write voltage generation unit 51 has two multiplexers MUX0 and MUX1. The voltage application unit 52 has a p-channel MOS transistor P0. The comparison unit 54 has an inverter INV3 and an XOR gate XOR0. The feedback unit 55 has a p-channel MOS transistor P1, two n-channel MOS transistors N0 and N1, and an inverter INV4. The write selection unit 56 has an AND gate AND0.

The feedback unit 55 operates such that in the case where the voltage V_{EN} of the write start signal line 18 becomes an on voltage, the p-channel MOS transistor P1 becomes conductive, and the n-channel MOS transistor N1 becomes insulated, causing the output voltage V_{WE} of the feedback unit 55 to be charged to an on voltage. Moreover, the voltage V_{EN} is a trigger signal that starts the writing, so once the voltage V_{WE} is charged to an on voltage, the voltage V_{EN} is set to an off voltage. The duration for which the voltage V_{EN} remains at the on voltage is preferably approximately 0.1 ns to 1 ns, but it is not limited to this range. In the case where the voltage V_{SE} of the write selection line 14 is an off voltage, no write operation occurs, so this discussion focuses only on the case where the voltage V_{SE} is an on voltage. The voltages V_{WE} and V_{WE2} become an on voltage, and the write operation begins. Subsequently, the voltage signal propagates in order from the write selection unit 56, the write voltage generation unit 51, the voltage application unit 52, the read unit 53, and the comparison unit 54.

The output voltage V_{CMP} of the comparison unit 54 is an on voltage in the case where the read data and the write data are equal, and an off voltage in the case where they differ. Alternatively, the output voltage V_{CMP} of the comparison unit 54 may be an off voltage in the case where the read data and the write data are equal, and an on voltage in the case where they differ. In the case of the circuit diagram illustrated in FIG. 8, the output voltage V_{CMP} of the comparison unit 54 is an on voltage in the case where the read data and the write data are equal, and an off voltage in the case where they differ. Then, in the case where the read data and the write data are different, that is, in the case where the writing is required to be continued, the n-channel MOS transistor N0 is insulated. As a result, the output voltage V_{WE} of the feedback unit 55 remains charged to an on voltage, and the writing continues. Conversely, in the case where the read data and the write data are equal, that is, in the case where the writing is required to be stopped, the n-channel MOS transistor N0 is made conductive. Additionally, as described earlier, the voltage V_{EN} is an off voltage for the n-channel MOS transistor N1, so this is also made conductive. Then, the charge stored in the output terminal of the feedback unit 55 is discharged through the n-channel MOS transistor N0 and the n-channel MOS transistor N1. As a result, the output voltage V_{WE} of the feedback unit 55 becomes the off voltage, and the writing is stopped.

As described previously, by using the write unit 50 according to the present embodiment, it is possible to implement a self-adaptive write operation in which the write operation is continued in the case where the read data and the write data are different, and the writing is stopped in the case where they become the same. For example, there is no need to control the pulse width of the write voltage, that is, the write pulse width, it is possible to reduce the write error rate and improve the stability of the write operation. Normally, the optimal write pulse width varies among magnetoresistive elements 120, but since an appropriate write pulse width is automatically set for each of these magnetoresistive elements 120, the write error rate can be reduced.

Moreover, the read unit 53 illustrated in FIG. 8 can be configured in any way as long as it can read the state of the selected magnetoresistive element 120. In addition, the write data line 17 (WD) can be used to perform the read operation. In other words, it can have the bit line 12 (BL) and the write data line 17 (WD) as input terminals, and a read data line RD as an output terminal. The bit line 12 may be hereinafter referred to as a bit line BL, and the write data line 17 may be referred to as a write data line WD, as appropriate, in alignment with the read data line RD.

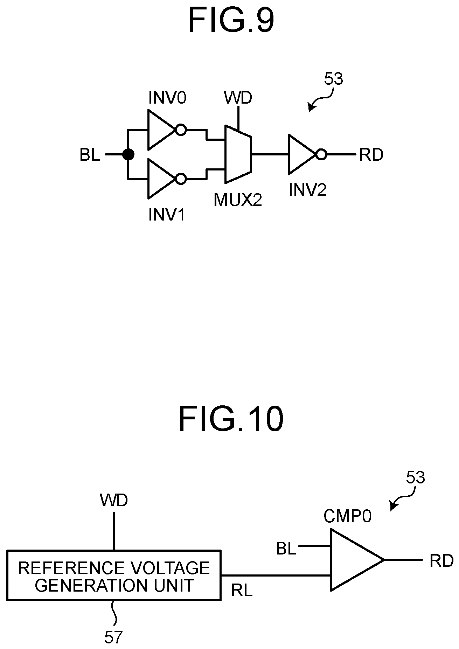

FIG. 9 illustrates an example of the configuration of the read unit 53. The read unit 53 illustrated in FIG. 9 has three inverters INV0, INV1, and INV2, and one multiplexer MUX2. The bit line BL is connected to the input terminal of each of the two inverters INV0 and INV1, which have different threshold voltages. The individual output terminals of the inverters INV0 and INV1 are connected to the respective input terminals of the multiplexer MUX2, and the output terminal of the multiplexer MUX2 is connected to the input terminal of the inverter INV2. The output terminal of the inverter INV2 is connected to the read data line RD.

The multiplexer MUX2 has the write data line WD as another input terminal. This multiplexer MUX2 connects one of the output terminals of the two inverters INV0 and INV1 to the input terminal of the inverter INV2 depending on the voltage of the write data line WD. The method of setting the individual threshold voltages of the two inverters INV0 and INV1 will be described later.

FIG. 10 illustrates another example of the configuration of the read unit 53. The read unit 53 illustrated in FIG. 10 has a comparator CMP0. This comparator CMP0 has, as input terminals, the bit line BL and the reference line RL, which is the output terminal of a reference voltage generation unit 57. The voltage of the reference line RL is denoted as V_{RL}. The read unit 53 illustrated in FIG. 10 compares the magnitudes of the voltage V_{BL} and the voltage V_{RL}, and outputs an on voltage to the read data line RD if the voltage V_{BL} is greater than the voltage V_{RL}, and outputs an off voltage to the read data line RD if the voltage V_{BL} is less than the voltage V_{RL}.

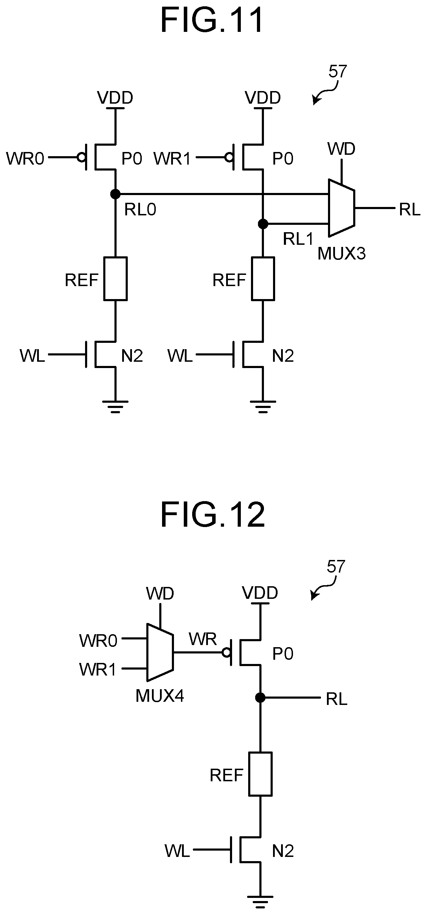

FIG. 11 illustrates an example of the configuration of the reference voltage generation unit 57. The reference voltage generation unit 57 illustrated in FIG. 11 has two p-channel MOS transistors P0 (voltage application unit 52 illustrated in FIG. 8), two reference resistors REF, two n-channel MOS transistors N2, and a multiplexer MUX3. In the example of FIG. 11, the p-channel MOS transistor P0, the reference resistor REF, and the n-channel MOS transistor N2 are connected in parallel. The multiplexer MUX3 has, as input terminals, a reference line RL0 corresponding to the writing state 0, a reference line RL1 corresponding to the writing state 1, and the write data line WD.

The reference resistor REF has a resistance value different from the resistance value of the magnetoresistive element 120 of the memory cell 100. Specifically, it is preferable that the reference resistor REF is an intermediate resistance between the resistance value in the case where the magnetoresistive element 120 is in the state 0 and the resistance value in the case where the magnetoresistive element 120 is in the state 1. In this way, the voltage V_{RL0} of the reference line RL0 corresponding to the writing state 0 is greater than the bit line voltage V_{BL} if the selected magnetoresistive element 120 is in the state 0 in the case of the writing state 0, and is less than the bit line voltage V_{BL} if the selected magnetoresistive element 120 is in the state 1 in the case of the writing state 0. Similarly, the voltage V_{RL1} of the reference line RL1 corresponding to the writing state 1 is greater than the bit line voltage V_{BL} if the selected magnetoresistive element 120 is in the state 0 in the case of the writing state 1, and is less than the bit line voltage V_{BL} if the selected magnetoresistive element 120 is in the state 1 in the case of the writing state 1. Then, one of the two reference lines RL0 and RL1 is selected depending on the write data line WD and is output to the reference line RL. In this way, the read data line RD of the read unit 53 illustrated in FIG. 10 becomes an off voltage if the selected magnetoresistive element 120 is in the state 0, and becomes an on voltage if the selected magnetoresistive element 120 is in the state 1.

FIG. 12 is another example of the configuration of the reference voltage generation unit 57. The reference voltage generation unit 57 illustrated in FIG. 12 has one p-channel MOS transistor P0 (voltage application unit 52 illustrated in FIG. 8), one reference resistor REF, one n-channel MOS transistor N2, and a multiplexer MUX4. The multiplexer MUX4 has, as input terminals, a state-0 write voltage line WR0, a state-1 write voltage line WR1, and the write data line WD. This multiplexer MUX4 selects the voltage of the state-0 write voltage line WR0 or the voltage of the state-1 write voltage line WR1 depending on the write data line WD and outputs the selected one as the voltage of the write voltage line WR, thereby making it possible to obtain an output equivalent to that of the reference voltage generation unit 57 illustrated in FIG. 11.

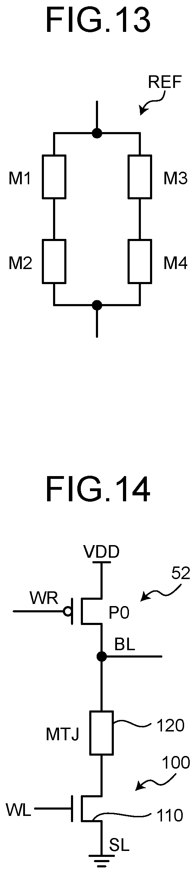

FIG. 13 is a circuit diagram illustrating an example of the configuration of the reference resistor REF illustrated in FIGS. 11 and 12. The reference resistor REF illustrated in FIG. 13 has, as four resistors, magnetoresistive elements M1 to M4 having the same structure as the magnetoresistive element 120 of the memory cell 100. For example, by setting the magnetoresistive elements M1 and M3 to the state 0 and the magnetoresistive elements M2 and M4 to the state 1, the resistance value of the reference resistor REF can be set to an intermediate value between the resistance value in the case where the magnetoresistive element 120 is in the state 0 and the resistance value in the case where the magnetoresistive element 120 is in the state 1. In other words, by using multiple magnetoresistive elements M1 to M4, it is possible to generate an intermediate value between the resistance value in the case where the magnetoresistive element 120 is in the state 0 and the resistance value in the case where the magnetoresistive element 120 is in the state 1. The configuration of the reference resistor REF is not limited to that illustrated in FIG. 13, and can have any configuration.

### <1-5. Simulation results>

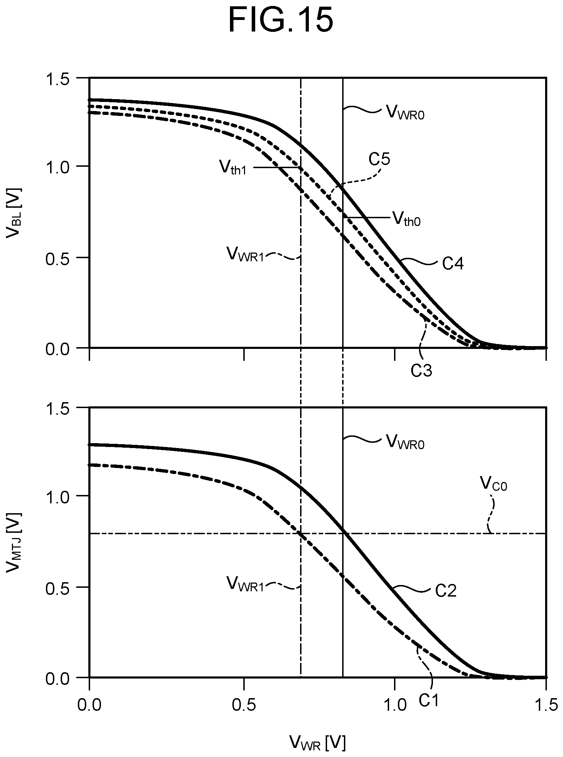

The simulation results of the self-adaptive writing in the present embodiment are now described with reference to FIGS. 14 and 15. FIG. 14 is a circuit diagram of the voltage application unit 52 and the memory cell 100 configured for the simulation. FIG. 15 is a first example of the simulation result according to the present embodiment.

In the example of FIG. 14, the magnetoresistive element 120 is an MTJ (MTJ element), the selection element 110 is an n-channel MOS transistor, and the voltage application unit 52 is a p-channel MOS transistor. The source line SL was grounded, and the power supply voltage VDD and the word line voltage of the word line WL were set to 1.5 V. Additionally, the bit line voltage of the bit line BL is set to V_{BL}, the voltage of the write voltage line WR is set to V_{WR}, and the voltage applied to the magnetoresistive element 120 is set to V_{MTJ}.

To perform the writing using the VCMA effect, it is necessary to apply a voltage (write voltage) to the magnetoresistive element 120 to reduce the magnetic anisotropy of the storage layer 124 to zero. The voltage V_{MTJ} at which the magnetic anisotropy of the storage layer 124 becomes zero is set to V_{c0}. Since the voltage V_{MTJ} depends on the voltage V_{WR} of the write voltage line, this voltage is required to be adjusted so that the voltage V_{MTJ} is V_{c0}. In this event, it should be noted that the voltage V_{WR} at which the voltage V_{MTJ} becomes equal to V_{c0} differs between the case where the magnetoresistive element is in the state 0 and the case where it is in the state 1. The voltage V_{WR} at which the voltage V_{MTJ} becomes equal to V_{c0} in the case where the magnetoresistive element 120 is in the state 1 is denoted as V_{WR0}, and the voltage V_{WR} at which the voltage V_{MTJ} becomes equal to V_{c0} in the case where the magnetoresistive element 120 is in the state 0 is denoted as V_{WR1}.

FIG. 15 is a diagram illustrated to describe a first example of the simulation result according to the present embodiment. The lower graph in FIG. 15 is a graph plotting the relationship between the voltage V_{MTJ} and the voltage V_{WR}. In this graph, a curve C1 corresponds to the case where the magnetoresistive element 120 is in the state 0, and a curve C2 corresponds to the case where the magnetoresistive element 120 is in the state 1. In the curve C1, the voltage V_{WR} at which the voltage V_{MTJ} is equal to V_{c0} is the voltage V_{WR1} used in the case of writing the state 1 to the magnetoresistive element 120. Similarly, in the curve C2, the voltage V_{WR} at which the voltage V_{MTJ} is equal to V_{c0} is the voltage V_{WR0} used in the case of writing the state 0 to the magnetoresistive element 120.

The upper graph in FIG. 15 is a graph plotting the relationship between the voltage V_{BL} and the voltage V_{WR}. In this graph, a curve C3 corresponds to the case where the magnetoresistive element 120 is in the state 0, and a curve C4 corresponds to the case where the magnetoresistive element 120 is in the state 1. A curve C5 is the average of the curves C3 and C4. In the curve C5, the voltage V_{BL} in the case where the voltage V_{WR} is V_{WR0} is set to Vₜₕ₀. This voltage can be used as the threshold voltage of the inverter INV0 that constitutes the read unit 53 illustrated in FIG. 9. In the curve C5, the voltage V_{BL} in the case where the voltage V_{WR} is V_{WR1} is set to Vₜₕ₁. This voltage can be used as the threshold voltage of the inverter INV1 that constitutes the read unit 53 in FIG. 9.

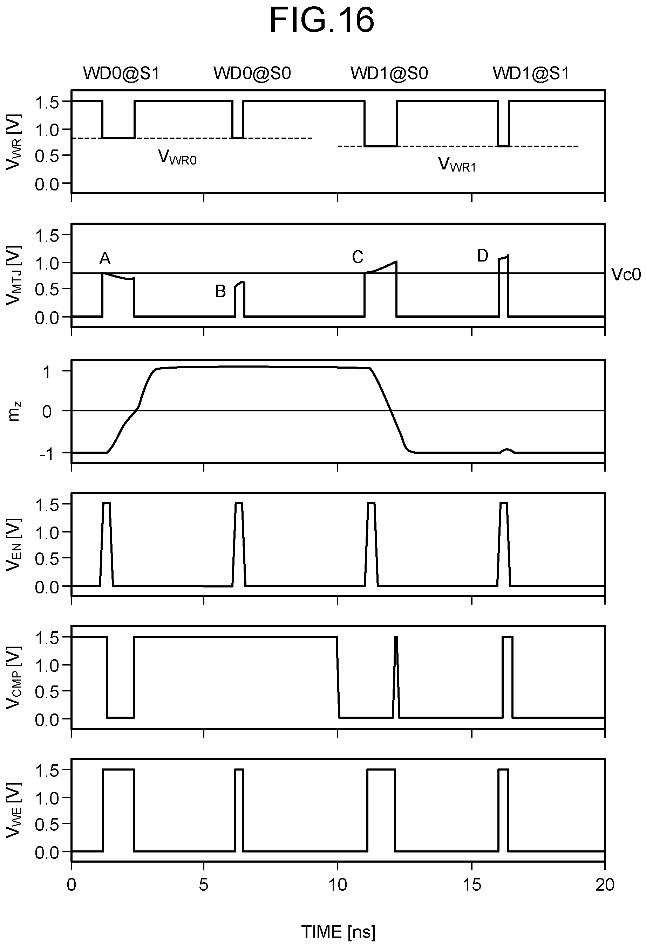

FIG. 16 is a second example of the simulation result according to an embodiment of the present disclosure. In FIG. 8, the read unit 53 illustrated in FIG. 9 was used as the read unit 53.

In FIG. 16, the voltage V_{EN} becomes an on voltage with a pulse width of 0.3 ns starting at 1 ns, 6 ns, 11 ns, and 16 ns, and the write operation begins. At 1 ns, the state 0 is written to the magnetoresistive element 120, which is initially in the state 1. At 6 ns, the state 0 is written to the magnetoresistive element 120 in the state 0. At 11 ns, the state 1 is written to the magnetoresistive element 120 in the state 0. At 16 ns, the state 1 is written to the magnetoresistive element 120 in the state 1. In other words, the writing is necessary at 1 ns and 11 ns, and writing is not necessary at 6 ns and 16 ns.

The voltage V_{MTJ} is equal to V_{c0}, indicated by the horizontal line, at 1 ns (A) and 11 ns (C), where the writing is necessary. In other words, ideal precessional motion occurs. On the other hand, at 6 ns (B) and 16 ns (D), where the writing is unnecessary, the voltage V_{EN} becomes the off voltage and the voltage V_{MTJ} becomes the off voltage at the same time, so that the write operation is interrupted. In the case where the writing is necessary, the voltage V_{WE} is maintained at the on voltage even if the voltage V_{EN} becomes the off voltage, so that the write operation continues. Then, in the case where the magnetization of the storage layer 124 is reversed (refer to the graph of the perpendicular component of magnetization m_{z}) and the writing is completed, the voltage V_{WE} becomes the off voltage, and the write operation is interrupted. As described previously, it can be seen that a self-adaptive write mechanism is achieved, which controls the continuation or interruption of the write operation while monitoring the current state.

### <1-6. Second configuration example of write unit>

A second configuration example of the write unit 50 according to the present embodiment is now described with reference to FIGS. 7, 17, and 18.

As illustrated in FIG. 7, the write unit 50 according to the second configuration example includes a write voltage generation unit 51, a voltage application unit 52, a read unit 53, a comparison unit 54, a feedback unit 55, and a write selection unit 56, similar to the write unit 50 according to the first configuration example. However, the write voltage generation unit 51 of the write unit 50 according to the second configuration example does not have the state-0 write voltage line 15 (WR0) and the state-1 write voltage line 16 (WR1) illustrated in FIG. 7 as input terminals, but, instead, has a write data line 17 (WD) and a write signal line 19 (WE2) as input terminals. Further details will be described later.

The write data line 17 is connected to the write control unit 40. The write signal line 19 is connected to the write selection unit 56. Under the control by the write control unit 40, an off voltage is applied to the write data line 17 in the case of writing the state 0, and an on voltage is applied in the case of writing the state 1. Moreover, the off voltage is a voltage that, in the case of being applied to the gate voltage of an n-channel MOS transistor, causes the drain terminal and the source terminal of the n-channel MOS transistor to become non-conductive, and can be, for example, a ground voltage. Additionally, the on voltage is a voltage that, in the case of being applied to the gate voltage of an n-channel MOS transistor, causes the drain terminal and the source terminal of the n-channel MOS transistor to become conductive, and can be, for example, a power supply voltage. The voltage of the write data line 17 is denoted as V_{WD}.

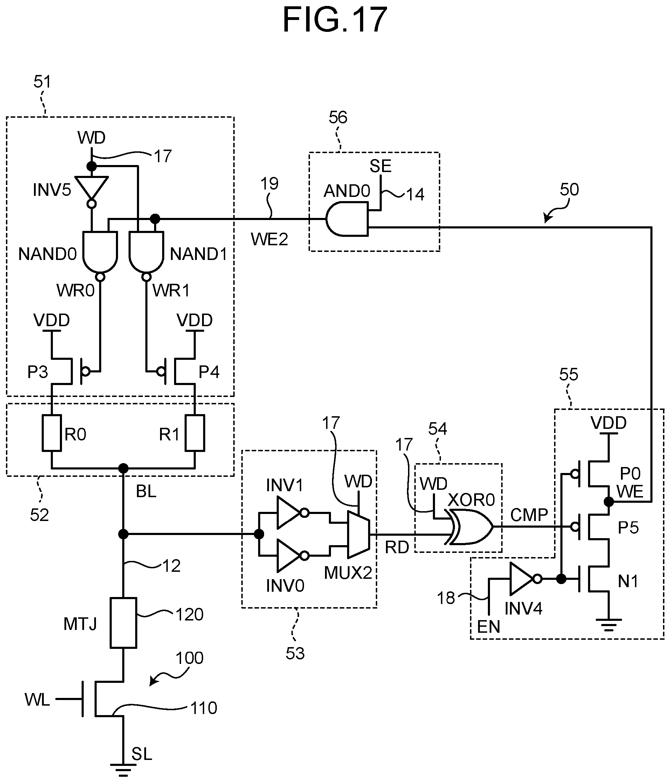

The write voltage generation unit 51 of the write unit 50 according to the second configuration example is now described with reference to FIG. 17, but the operations of the read unit 53, the comparison unit 54, the feedback unit 55, and the write selection unit 56 are similar to those of the first configuration example of the write unit of this disclosure, and thus redundant descriptions will be omitted.

FIG. 17 is a more detailed circuit diagram of the write unit 50 according to the second configuration example. However, FIG. 17 is merely one example of the configuration of the write unit 50, and the write unit 50 is not limited to this configuration. Moreover, the operation of the circuit diagram illustrated in FIG. 17 can be easily understood by comparing it with the description of FIG. 7 mentioned previously, but some supplementary descriptions will be provided. Additionally, descriptions of parts that overlap with FIG. 8 will be omitted. In the example of FIG. 17, the read unit 53 has the same configuration as the read unit 53 illustrated in FIG. 9.

The write voltage generation unit 51 illustrated in FIG. 17 has an inverter INV5, two NAND gates NAND0 and NAND1, and two p-channel MOS transistors P3 and P4. In the example of FIG. 17, the p-channel MOS transistor P3 connected to a load resistor R0 and the p-channel MOS transistor P4 connected to a load resistor R1 are arranged in parallel.

The write voltage generation unit 51 applies a voltage to the load resistors R0 and R1 provided in the voltage application unit 52 according to the voltages of the write data line 17 (WD) and the write signal line 19 (WE2). For the load resistors R0 and R1, any resistive element can be used, but they may be resistive elements having a film structure equivalent to that of the magnetoresistive element 120 that constitutes the memory cell 100. Additionally, in FIG. 17, the load resistors R0 and R1 are each a single resistive element, but one or both of the load resistors R0 and R1 may be configured with a plurality of resistive elements connected in any desired configuration. In the write voltage generation unit 51, the voltages V_{WD} and V_{WE2} (their respective voltage values) are either ground voltage or power supply voltage, so V_{WR0} and V_{WR1} are also either ground voltage or power supply voltage. In this way, compared to the first configuration example of the write unit 50 according to the present embodiment, there is no need to input an intermediate potential from an external source.

As described previously, to perform ideal precessional motion, it is necessary that the voltage V_{MTJ} is equal to V_{c0}. To apply a specific voltage to the magnetoresistive element 120 in this way, the load resistors R0 and R1 are used. The load resistor R0 is used in the case of performing a state-0 writing, and the load resistor R1 is used in the case of performing a state-1 writing. The setting of the resistance values of the load resistors R0 and R1 is described in the simulation mentioned later.

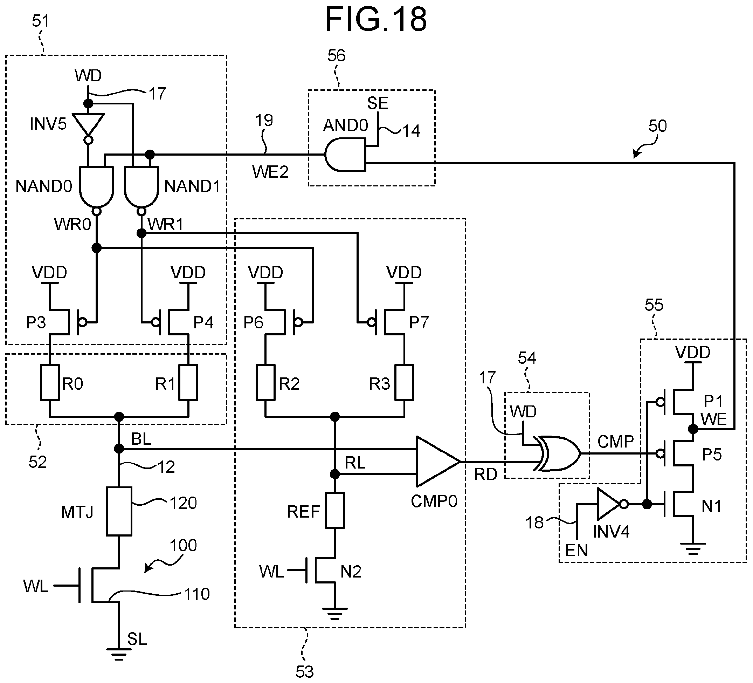

FIG. 18 is a more detailed circuit diagram of the write unit 50 according to the third configuration example. However, FIG. 18 is merely one example of the form of the write unit 50, and the write unit 50 is not limited to this form. Moreover, descriptions of parts that overlap with FIG. 17 will be omitted.

The read unit 53 illustrated in FIG. 18 differs from the read unit 53 illustrated in FIG. 17 in that it has two p-channel MOS transistors P6 and P7, two load resistors R2 and R3, a reference resistor REF, one n-channel MOS transistor N2, and a comparator CMP0. In the example of FIG. 18, the connection of the p-channel MOS transistor P6 to the load resistor R2 and the connection of the p-channel MOS transistor P7 to the load resistor R3 are arranged in parallel. Using these load resistors R2 and R3, a reference voltage V_{RL} can be generated.

The connection of the p-channel MOS transistor P6 to the load resistor R2 and the connection of the p-channel MOS transistor P7 to the load resistor R3 are also arranged in parallel with the connection of the p-channel MOS transistor P3 of the write voltage generation unit 51 to the load resistor R0 of the voltage application unit 52 and the connection of the p-channel MOS transistor P4 in the write voltage generation unit 51 to the load resistor R1 in the voltage application unit 52.

Moreover, it is desirable for the load resistors R2 and R3 to have the same configuration as the load resistors R0 and R1, but they are not limited to such a configuration. Additionally, the reference resistor REF provided in the read unit 53 can have a similar configuration to that illustrated in FIG. 13. Other operations are similar to those of the first configuration example of the write unit 50 according to the present embodiment, so further description will be omitted.

### <1-7. Simulation results>

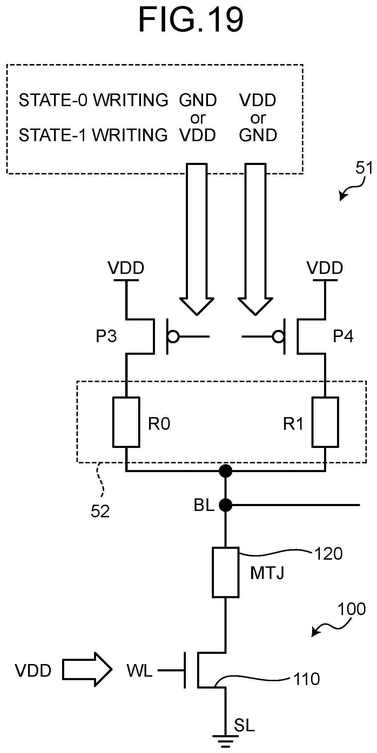

The results of simulating the self-adaptive writing in the present embodiment are now described with reference to FIGS. 19 to 22.

FIG. 19 is a circuit diagram illustrating a configuration example of the write voltage generation unit 51, voltage application unit 52, and memory cell 100 configured for the simulation. In the example of FIG. 19, the magnetoresistive element 120 is an MTJ (MTJ element), the selection element 110 is an n-channel MOS transistor, and the voltage application unit 52 has two load resistors R0 and R1. The source line SL was grounded (GND), and the power supply voltage VDD was set to 1.5 V. In the case of the state-0 writing, the gate voltage of the p-channel MOS transistor P3 was set to GND to be in the on state, and the gate voltage of the p-channel MOS transistor P4 was set to VDD to be in the of state. Conversely, in the case of the state-1 writing, the gate voltage of the p-channel MOS transistor P4 was set to GND to be in the on state, and the gate voltage of the p-channel MOS transistor P3 was set to VDD to be in the off state. In either case, the gate voltage of the n-channel MOS transistor of the selection element 110 was set to VDD to be in the on state.

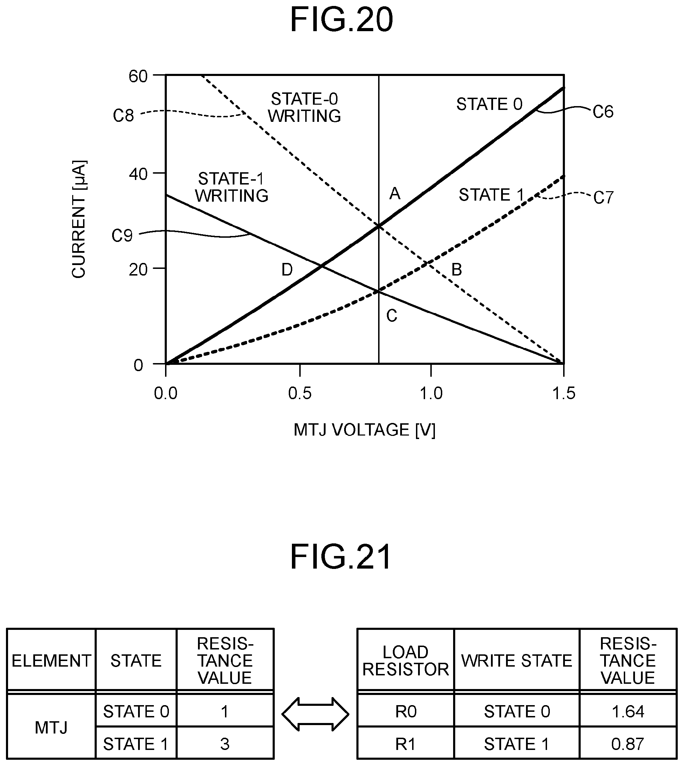

FIG. 20 is a diagram illustrated to describe a third example of the simulation result according to the present embodiment. The resistance value of the magnetoresistive element 120 was set to 30 kΩ in the 0 state and 90 kΩ in the state 1. The horizontal axis represents the voltage of the magnetoresistive element 120 (MTJ voltage = V_{MTJ}), and the vertical axis represents the current flowing through the magnetoresistive element 120. A curve C6 is the voltage-current characteristics in the case where the magnetoresistive element 120 is in the state 0, and a curve C7 is the voltage-current characteristics in the case where the magnetoresistive element 120 is in the state 1. Additionally, a curve C8 is the load curve of the load resistor R0 used in the case of the state-0 writing. The horizontal axis is V_{MTJ}, so the current value is 0 in the case where V_{MTJ} is equal to VDD (1.5 V). Similarly, a curve C9 is the load curve of the load resistor R1 used in the case of the state-1 writing. If the resistance values of the load resistors R0 and R1 change, the curves C8 and C9 will shift up and down accordingly on the graph. Then, it is understood that the resistance values of the load resistors R0 and R1 can be set so that the voltages of operating points A and C at which the writing is to be performed are exactly V_{c0}.

FIG. 21 is a diagram illustrated to describe the load resistors R0 and R1 based on the third example of the simulation result according to the present embodiment. As illustrated in FIG. 21, the simulation result revealed that in the case where the resistance value of the magnetoresistive element 120 in the state 0 is normalized to 1 and the resistance value of the magnetoresistive element 120 in the state 1 is normalized to 3, the value of the load resistor R0 is 1.64, and the value of the load resistor R1 is 0.87.

Moreover, as described previously, the load resistor R0 and the load resistor R1 may be configured using a magnetoresistive element. In this case, the load resistor R0 and the load resistor R1 can be configured using the same magnetic film as the magnetoresistive element 120 of the memory cell 100. In such a case, the desired resistance value can be obtained by setting the reciprocal of the resistance ratio of the load resistor R0 and the load resistor R1 to the area ratio. In addition, in the case where it is difficult to form a load resistor with an area smaller than that of the magnetoresistive element 120 from the viewpoint of process technology, for example, by connecting a load resistor with a large area in series, it is possible to set a value such that the voltages at the operating points A and C are exactly V_{c0}, as described previously.

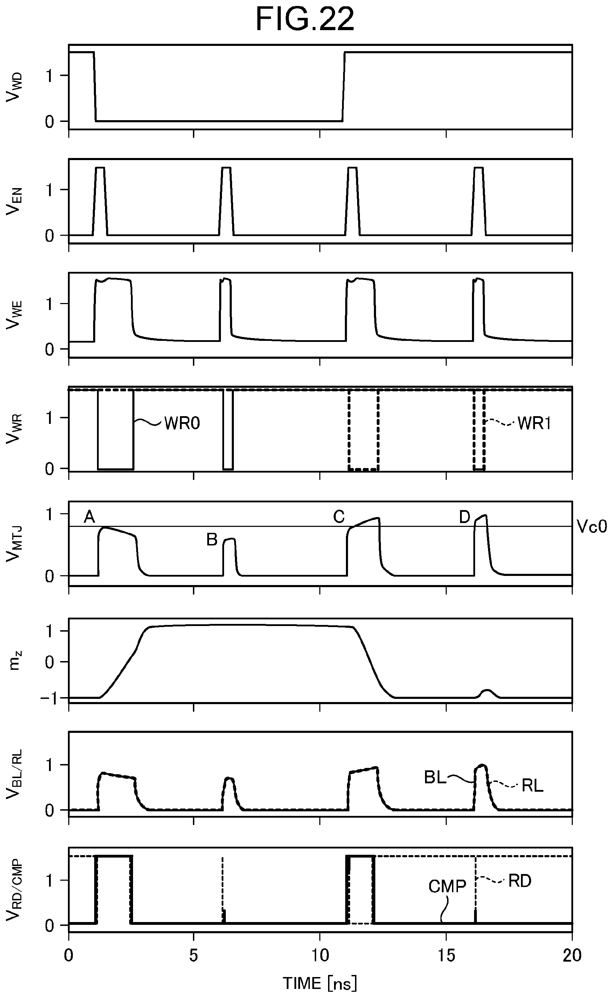

FIG. 22 is a diagram illustrated to describe a fourth example of the simulation result according to the present embodiment. The write unit 50 illustrated in FIG. 18 was used for this simulation. The initial state of the magnetoresistive element was set to the state 1 (m_{z} = -1). In the first half of the simulation, the voltage V_{WD} (write data WD) is set to 0, and the state-0 writing is performed. In the second half, the voltage V_{WD} was set to 1, and the state-1 writing is performed.

The voltage V_{EN} (signal EN used for starting the writing) was set to an on voltage (on state) with a pulse width of 0.3 ns at 1 ns, 6 ns, 11 ns, and 16 ns. The transition of the voltage V_{EN} to an on voltage causes the voltage V_{WE} (write enable signal WE) to transition to an on voltage (on state), and the writing begins. First, at the time of 1 ns, the write data WD is 0, while the initial state of the magnetoresistive element 120 is state 1, so the writing is required to be performed. Thus, even after the voltage V_{EN} becomes an off voltage, the voltage V_{WE} remains in the on state, and the write operation continues. The magnetoresistive element 120 undergoes a state change around 2 ns due to precessional motion. Then, this state change is detected by the read unit 53, causing the voltage V_{WE} to become the off voltage. In this way, the magnetoresistive element 120 has undergone a state change, the application of the write voltage to the magnetoresistive element 120 is ceased, suppressing unnecessary magnetization dynamics. The magnetoresistive element 120 settles to the state 0 (m_{z} = 1) around approximately 3 ns.

Next, at the time of 6 ns, the voltage V_{WD} is 0, while the magnetoresistive element 120 is in the state 0, so writing is not required. Thus, at the same time that the voltage V_{EN} becomes the off state, the voltage V_{WE} also becomes the off state, and the write operation is interrupted. In this way, in the case where the writing is unnecessary, erroneous writing can be suppressed by promptly stopping the application of the write voltage.

Moreover, the write operation after 11 ns follows the same procedure as described previously, with the exception that the voltage V_{WD} is set to 1.

Next, attention is given to the voltage applied to the magnetoresistive element 120 at the start of the writing. In the fifth graph from the top of FIG. 22, V_{MTJ} = V_{c0} is indicated by a horizontal line. In the case where the writing is required, the resistance value of the load resistors (e.g., each of the load resistors R0, R1, R2, and R3) was adjusted so that V_{MTJ} = V_{c0}. In fact, as illustrated in FIG. 22, at 1 ns (A) and 11 ns (C), V_{MTJ} = V_{c0} at the start of the writing, and ideal precessional motion begins. On the other hand, at 6 ns (B) where the state-0 writing is performed in the state 0, the resistance value of the magnetoresistive element 120 is low, so V_{MTJ} < V_{c0}, and no precessional motion occurs. Additionally, at 16 ns (D) where the state-1 writing is performed in the state 1, the resistance value of the magnetoresistive element 120 is high, so V_{MTJ} > V_{c0}, and in-plane precessional motion occurs. Of course, these voltages are quickly no longer applied due to self-adaptation, but if only the magnitude of the voltage applied to the magnetoresistive element 120 is focused, it reveals that the operation is similar to non-toggle-type writing. In other words, the writing method in this case can be said to be self-adaptive and non-toggle type at the same time.

In this way, independent of the initial state, the non-toggle-type writing is performed by applying different voltages for the state-0 writing and the state-1 writing. In other words, non-toggle-type writing is possible, which eliminates the need to perform reading in the initial state prior to the writing. As a result, the time and power consumption required for initial state reading can be reduced, enabling higher-speed, lower-power writing.

Moreover, the write operation may be an operation in which writing is performed only once (single write operation) or an operation in which writing is repeated multiple times in succession (continuous write operation). By performing the writing multiple times, it is possible to reduce the write error rate. However, while the optimal write pulse width may vary among the magnetoresistive elements 120 in the memory cell array 10, by using the write unit 50, as described previously, the write pulse width becomes an appropriate pulse width for each magnetoresistive element 120, thereby reducing the write error rate. This makes it possible to eliminate the need to perform continuous write operations in the case where the write error is caused by the variation in the optimal pulse width for each magnetoresistive element 120. Moreover, the optimal write voltage (amplitude of the pulse voltage) may vary among the magnetoresistive elements 120 in the memory cell array 10, so the write error rate can be reduced by performing write operations multiple times with different voltages.

Furthermore, the continuous write operation may be a continuous write process with a verify function. In the verify function, data is read from the target memory cell 100, and it is determined whether the read data matches the write data. If the read data matches the write data, the process ends, and if the read data does not match the write data, the writing is repeated. Additionally, the continuous write operation may be a continuous write process with a verify function that accompanies an initial reading. In the initial reading, data is read from the target memory cell 100 to determine whether writing should begin, and it is determined whether the read data matches the write data. If the read data matches the write data, the process ends, and if the read data does not match the write data, the writing begins.

### <1-8. Operation and effects>

As described previously, according to the present embodiment, the memory system 1, which is an example of the storage device, includes the magnetoresistive element 120 with the resistance state changing in the case of applying a voltage, the selection element 110 connected to the magnetoresistive element 120, the control line (e.g., bit line 12) connected to the side of the magnetoresistive element 120 opposite to the selection element 110, the voltage application unit 52 connected to the control line to output a voltage to the magnetoresistive element 120, and the read unit 53 connected to the control line to read the resistance state of the magnetoresistive element 120, and the read unit 53 reads the resistance state of the magnetoresistive element 120 during the write operation in which the voltage application unit 52 outputs a voltage to the magnetoresistive element 120, and the voltage application unit 52 controls the write operation according to the resistance state of the magnetoresistive element 120 read by the read unit 53. This configuration enables the voltage application unit 52 and the read unit 53 to be connected to the bit line 12, which is an example of a control line, thereby eliminating the need for individual monitoring wires for each memory cell and allowing for self-adaptive writing without increasing the memory cell area. Additionally, independent of the initial state prior to writing, the voltage applied to the magnetoresistive element 120 at the start of writing can be made equal to the voltage that eliminates the perpendicular magnetic anisotropy of the storage layer 124, resulting in improved writing stability.

Additionally, the voltage application unit 52 continues the write operation in the case where the resistance state of the magnetoresistive element 120, as read by the read unit 53, differs from the target resistance state of the magnetoresistive element 120 (e.g., write data), and the voltage application unit 52 stops the write operation in the case where the resistance state of the magnetoresistive element 120, as read by the read unit 53, is the same as the target resistance state of the magnetoresistive element 120. This enables the self-adaptive writing and improved stability of the write operation to be reliably achieved.

Additionally, in the case where the resistance state of the magnetoresistive element 120, as read by the read unit 53, is the same as the target resistance state of the magnetoresistive element 120, the voltage application unit 52 may output a voltage (e.g., power supply voltage or ground voltage) to the magnetoresistive element 120 to stop the write operation. This enables the self-adaptive writing and improved stability of the write operation to be reliably achieved.

Additionally, the memory system 1 may further include the write voltage generation unit 51 that outputs to the voltage application unit 52 a voltage that contributes to the voltage output by the voltage application unit 52 depending on the target resistance state of the magnetoresistive element 120 (refer to FIG. 7). This enables the self-adaptive writing and improved stability of the write operation to be reliably achieved.

In addition, the write voltage generation unit 51 may output an off voltage or an on voltage to the voltage application unit 52 depending on a write selection voltage that indicates whether or not a write operation is to be performed. This enables the self-adaptive writing and improved stability of the write operation to be reliably achieved.

Furthermore, the write voltage generation unit 51 may output an off voltage or an on voltage to the voltage application unit 52 in the case where the write selection voltage is a voltage that indicates that a write operation is not to be performed, independent of the target resistance state of the magnetoresistive element 120. This enables the self-adaptive writing and improved stability of the write operation to be reliably achieved.

Additionally, the memory system 1 may further include the comparison unit 54 that compares whether the resistance state of the magnetoresistive element 120 read by the read unit 53 is the same as or different from the target resistance state of the magnetoresistive element 120 (refer to FIG. 7). This enables the self-adaptive writing and improved stability of the write operation to be reliably achieved.

In addition, the memory system 1 may further include the feedback unit 55 that determines whether to continue or stop the write operation depending on the comparison result from the comparison unit 54 (refer to FIG. 7). This enables the self-adaptive writing and improved stability of the write operation to be reliably achieved.

Furthermore, the memory system 1 may further include the write selection unit 56 that selects whether to continue or stop the write operation depending on the determination result from the feedback unit 55, and the voltage application unit 52 may continue or stop the write operation depending on the selection result from the write selection unit 56. This enables the self-adaptive writing and improved stability of the write operation to be reliably achieved.

Furthermore, the read unit 53 may also have two inverters INV0 and INV1 with different threshold voltages (refer to FIG. 9). This enables the read unit 53 to be implemented with a simple configuration.

Additionally, the memory system 1 may also further include the reference voltage generation unit 57 that supplies a reference voltage to the read unit 53 (refer to FIG. 10). This enables the read unit 53 to be implemented with a simple configuration.

In addition, the reference voltage generation unit 57 may also have multiple reference resistors REF or a single reference resistor REF (refer to FIGS. 11 and 12). This enables the reference voltage generation unit 57 to be implemented with a simple configuration.

Furthermore, at least one of the multiple reference resistors or the single reference resistor REF may include multiple magnetoresistive elements (refer to FIG. 13). This enables the reference resistor REF to be implemented with a simple configuration.

Additionally, the voltage application unit 52 may also include multiple magnetoresistive elements that each function as a load resistor (e.g., load resistor R0 or load resistor R1). This enables the voltage application unit 52 to be implemented with a simple configuration.

In addition, at least two of the magnetoresistive elements of the voltage application unit 52 may be elements with different areas. This enables two magnetoresistive elements with different resistance values to be implemented with a simple configuration.

Furthermore, the read unit 53 may have the plurality of magnetoresistive elements each functioning as a load resistor (e.g., load resistor R2 or load resistor R3) (refer to FIG. 18). This enables the read unit 53 to be implemented with a simple configuration.

Additionally, at least two of the magnetoresistive elements of the read unit 53 may be elements with different areas. This enables two magnetoresistive elements with different resistance values to be implemented with a simple configuration.

In addition, the selection element 110 may have the drain terminal, the source terminal, and the gate terminal, one of the two terminals of the magnetoresistive element 120 may be connected to the bit line 12, which is a control line, the other terminal may be connected to the drain terminal, the source terminal may be connected to the source line 13, and the gate terminal may be connected to the word line 11 (refer to FIG. 3). Such a configuration also enables the self-adaptive writing and improved stability of the write operation to be reliably achieved.

Furthermore, the selection element 110 may have the drain terminal, the source terminal, and the gate terminal, one of the two terminals of the magnetoresistive element 120 may be connected to the source line 13, the other terminal may be connected to the source terminal, the drain terminal may be connected to the bit line 12, which is a control line, and the gate terminal may be connected to the word line 11 (refer to FIG. 4). Such a configuration also enables the self-adaptive writing and improved stability of the write operation to be reliably achieved.

### <2. Other embodiments>

The configurations and processes according to the above-mentioned embodiments (examples and modifications) may be implemented in various different forms other than the above-mentioned embodiments. For example, the configurations and processes are not limited to the examples given above and may take various forms. In addition, unless specifically stated otherwise, the processing procedures, specific names, and information including various data and parameters described and illustrated herein and drawings can be modified as desired.

Additionally, the configurations and processes according to the above-mentioned embodiments (examples and modifications) do not necessarily have to be physically configured as illustrated in the drawings. In other words, the specific form of distribution and integration of the components of each device is not limited to that illustrated in the drawings, and all or part of them can be functionally or physically distributed and integrated into any unit depending on various factors such as loads or usage conditions.

For example, each MTJ according to the above-mentioned embodiments and their modifications may be used as the magnetoresistive element 120 to configure a storage device such as a hard disk drive (HDD) or other types of storage devices.

### <3. Configuration example of electronic apparatus>

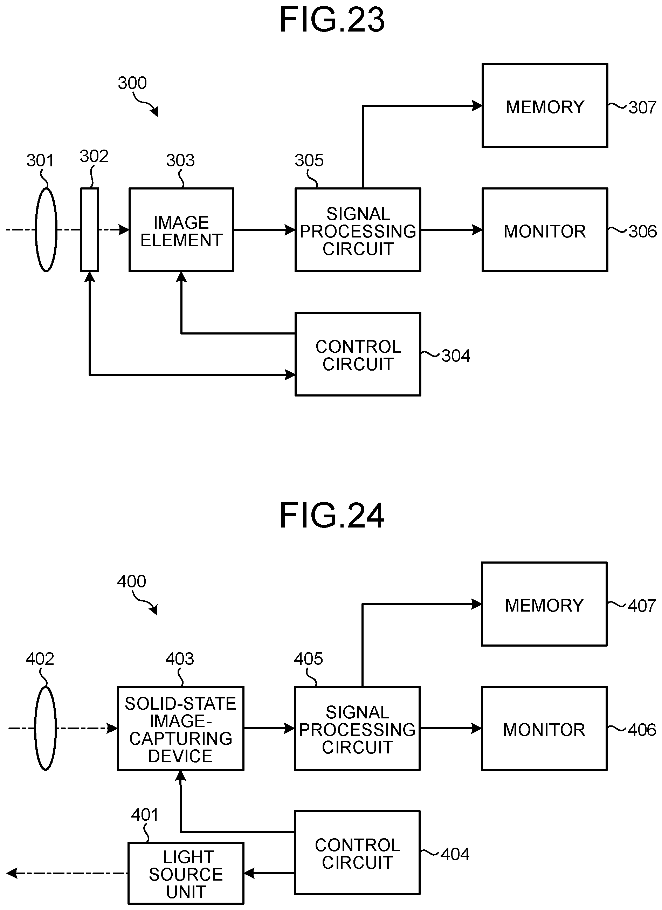

As an electronic apparatus to which the memory system 1 according to the above embodiment (including modifications) is applied, an imaging device 300, a distance measurement device 400, and a game apparatus 900 will be described with reference to FIGS. 23 to 26. For example, each of the imaging device 300, the distance measurement device 400, and the game apparatus 900 uses the memory system 1 according to each of the above embodiments as a memory. Examples of the memory include a flash memory and the like.

### <3-1. Imaging device>

The imaging device 300 to which the memory system 1 according to the above embodiment is applied will be described with reference to FIG. 23. FIG. 23 is a diagram illustrating an example of a schematic configuration of the imaging device 300. The imaging device 300 is an example of the electronic apparatus to which the memory system 1 according to the present embodiment is applied. Examples of the imaging device 300 include electronic devices such as a digital still camera, a video camera, a smartphone having an imaging function, and a mobile phone.

As illustrated in FIG. 23, the imaging device 300 includes an optical system 301, a shutter device 302, an imaging element 303, a control circuit (drive circuit) 304, a signal processing circuit 305, a monitor 306, and a memory 307. The imaging device 300 can capture a still image and a moving image.

The optical system 301 includes one or a plurality of lenses. The optical system 301 guides light (incident light) from a subject to the imaging element 303 and forms an image on a light receiving surface of the imaging element 303.

The shutter device 302 is disposed between the optical system 301 and the imaging element 303. The shutter device 302 controls a light irradiation period and a light shielding period with respect to the imaging element 303 according to the control of the control circuit 304.

The imaging element 303 accumulates signal charges for a certain period according to light formed on the light receiving surface via the optical system 301 and the shutter device 302. The signal charges accumulated in the imaging element 303 is transferred in accordance with a drive signal (timing signal) supplied from the control circuit 304.

The control circuit 304 outputs the drive signal for controlling a transfer operation of the imaging element 303 and a shutter operation of the shutter device 302 to drive the imaging element 303 and the shutter device 302.

The signal processing circuit 305 performs various types of signal processing on the signal charges output from the imaging element 303. An image (image data) obtained by performing the signal processing by the signal processing circuit 305 is supplied to the monitor 306 and also supplied to the memory 307.

The monitor 306 displays a moving image or a still image captured by the imaging element 303 based on the image data supplied from the signal processing circuit 305. As the monitor 306, for example, a panel type display device such as a liquid crystal panel or an organic electro luminescence (EL) panel is used.

The memory 307 stores the image data supplied from the signal processing circuit 305, that is, image data of the moving image or the still image captured by the imaging element 303. The memory 307 corresponds to the memory device 1 according to the above embodiment.

Also in the imaging device 300 configured in this manner, the self-adaptive writing and the improved writing stability can be reliably implemented by using the above-described memory system 1 as the memory 307.

### <3-2. Distance measurement device>

The distance measurement device 400 to which the memory system 1 according to the above embodiment is applied will be described with reference to FIG. 24. FIG. 24 is a diagram illustrating an example of a schematic configuration of the distance measurement device 400. The distance measurement device 400 is an example of the electronic apparatus to which the memory system 1 according to the present embodiment is applied.

As illustrated in FIG. 24, the distance measurement device (distance image sensor) 400 includes a light source unit 401, an optical system 402, a solid-state imaging device (imaging element) 403, a control circuit (drive circuit) 404, a signal processing circuit 405, a monitor 406, and a memory 407. The distance measurement device 400 can acquire a distance image according to a distance to a subject by projecting light from the light source unit 401 toward the subject and receiving light (modulated light or pulsed light) reflected from a surface of the subject.

The light source unit 401 projects light toward the subject. As the light source unit 401, for example, a vertical cavity surface emitting laser (VCSEL) array that emits laser light as a surface light source or a laser diode array in which laser diodes are arrayed on a line is used. Note that the laser diode array is supported by a predetermined drive unit (not illustrated), and is scanned in a direction perpendicular to the array direction of the laser diodes.

The optical system 402 includes one or a plurality of lenses. The optical system 402 guides light (incident light) from the subject to the solid-state imaging device 403 to form an image on a light receiving surface (sensor unit) of the solid-state imaging device 403.

The solid-state imaging device 403 stores signal charges according to the light of the image formed on the light receiving surface via the optical system 402. A distance signal indicating the distance obtained from a light reception signal (APD OUT) output from the solid-state imaging device 403 is supplied to the signal processing circuit 405. As the solid-state imaging device 403, for example, a solid-state imaging element such as an image sensor is used.

The control circuit 404 outputs a drive signal (control signal) for controlling operations of the light source unit 401, the solid-state imaging device 403, and the like to drive the light source unit 401, the solid-state imaging device 403, and the like.

The signal processing circuit 405 performs various types of signal processing on the distance signal supplied from the solid-state imaging device 403. For example, the signal processing circuit 405 performs image processing (for example, histogram processing, peak detection processing, and the like) of constructing the distance image on the basis of the distance signal. An image (image data) obtained by performing the signal processing by the signal processing circuit 405 is supplied to the monitor 406 and also supplied to the memory 407.

The monitor 406 displays the distance image captured by the solid-state imaging device 403 on the basis of the image data supplied from the signal processing circuit 405. As the monitor 406, for example, a panel type display device such as a liquid crystal panel or an organic EL panel is used.

The memory 407 stores the image data supplied from the signal processing circuit 405, that is, the image data of the distance image captured by the solid-state imaging device 403. The memory 407 corresponds to the memory system 1 according to the above embodiment.

Also in the distance measurement device 400 configured in this manner, the self-adaptive writing and the improved writing stability can be reliably implemented by using the above-described memory system 1 as the memory 407.

### <3-3. Game device>

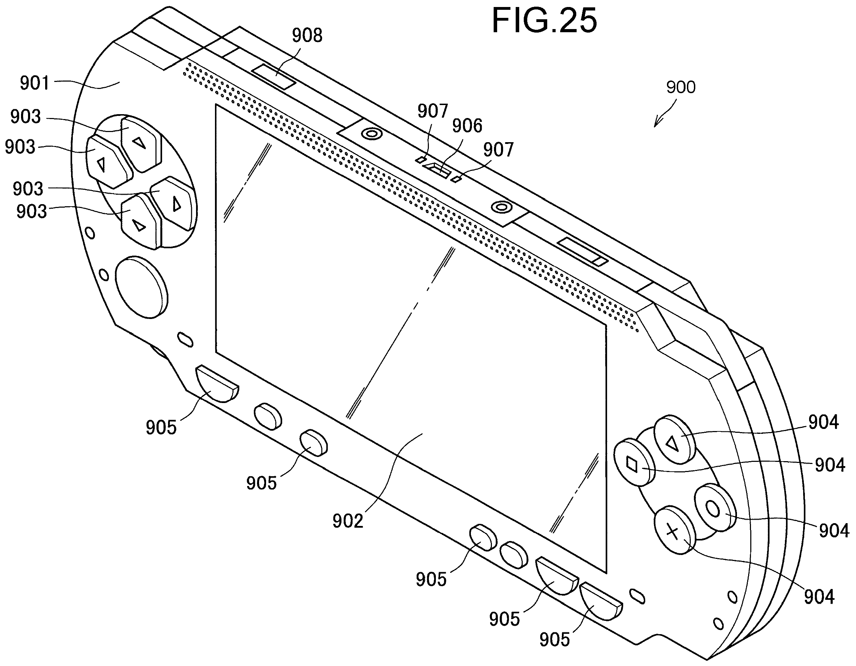

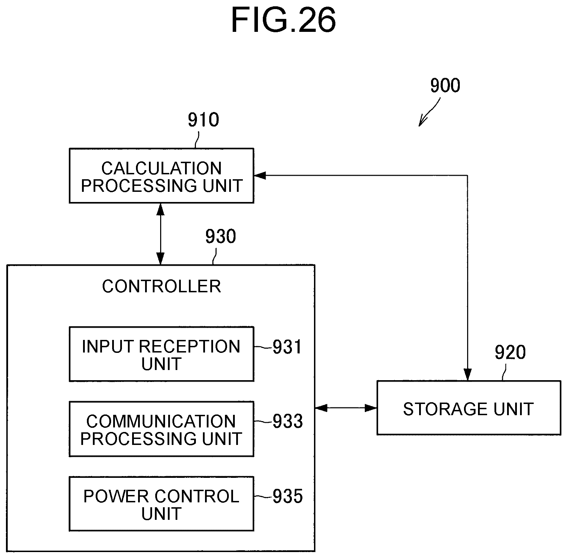

The game device 900 to which the memory system 1 according to the above embodiment is applied will be described with reference to FIGS. 25 and 26. FIG. 25 is a perspective view (external perspective view) illustrating an example of the schematic configuration of the game device 900. FIG. 26 is a block diagram illustrating an example of the schematic configuration of the game device 900. The game device 900 is an example of the electronic apparatus to which the memory system 1 according to the present embodiment is applied.

As illustrated in FIG. 25, for example, the game device 900 has an appearance in which each component is disposed inside and outside an outer casing 901 formed in a horizontally long flat shape.

On the front surface of the outer casing 901, a display panel 902 is provided at the center thereof in the longitudinal direction. Further, operation keys 903 and operation keys 904 are provided on the left and right sides of the display panel 902, respectively, spaced apart from each other in the circumferential direction. An operation key 905 is provided at a lower end of the front surface of the outer casing 901. The operation keys 903, 904, and 905 function as direction keys, determination keys, or the like, and are used for selection of menu items displayed on the display panel 902, progress of a game, or the like.

On the upper surface of the outer casing 901, a connection terminal 906 for connecting an external device, a power supply terminal 907, a light receiving window 908 for performing infrared communication with the external device, and the like are provided.

As illustrated in FIG. 26, the game device 900 includes an arithmetic processing unit 910 including a central processing unit (CPU), a storage unit 920 that stores various types of information, and a controller 930 that controls each configuration of the game device 900. Power is supplied to the arithmetic processing unit 910 and the controller 930 from, for example, a battery (not illustrated) or the like.

The arithmetic processing unit 910 generates a menu screen for allowing a user to set various types of information or select an application. In addition, the arithmetic processing unit 910 executes the application selected by the user.

The storage unit 920 stores various types of information set by the user. The storage unit 920 corresponds to the memory system 1 according to the above embodiment.

The controller 930 includes an input receiving unit 931, a communication processing unit 933, and a power controller 935. The input receiving unit 931 detects, for example, the states of the operation keys 903, 904, and 905. Furthermore, the communication processing unit 933 performs communication processing with an external device. The power controller 935 controls power supplied to each unit of the game device 900.

Also in the game device 900 configured in this manner, the self-adaptive writing and the improved writing stability can be reliably implemented by using the above-described memory system 1 as the storage unit 920.

It is noted that the memory system 1 according to each of the above-described embodiments may be mounted on the same semiconductor chip together with a semiconductor circuit forming an arithmetic device or the like to form a semiconductor device (System-on-a-Chip: SoC).

Furthermore, the memory system 1 according to the above embodiment can be mounted on various electronic devices on which a memory (storage unit) can be mounted as described above. For example, the memory system 1 may be mounted on various electronic devices such as a notebook personal computer (PC), a mobile device (for example, a smartphone, a tablet PC, or the like), a personal digital assistant (PDA), a wearable device, and a music device in addition to the imaging device 300 and the game device 900. For example, the memory system 1 is used as various memories such as a storage.

### <4. Supplementary notes>

Moreover, the present technology can also have the following configurations.
(1) A storage device comprising:
   a magnetoresistive element with a resistance state changing upon application of a voltage;
   a selection element connected to the magnetoresistive element;
   a control line connected to a side of the magnetoresistive element opposite to a side connected to the selection element;
   a voltage application unit connected to the control line to output a voltage to the magnetoresistive element; and
   a read unit connected to the control line to read the resistance state of the magnetoresistive element, wherein
   the read unit reads the resistance state of the magnetoresistive element during an operation in which the voltage application unit outputs the voltage to the magnetoresistive element, and
   the voltage application unit controls the operation depending on the resistance state of the magnetoresistive element read by the read unit.
(2) The storage device according to (1), wherein
   the voltage application unit continues the operation if the resistance state of the magnetoresistive element read by the read unit differs from a target resistance state of the magnetoresistive element, and stops the operation if the resistance state of the magnetoresistive element read by the read unit is identical to the target resistance state of the magnetoresistive element.
(3) The storage device according to (2), wherein
   the voltage application unit outputs a voltage used for stopping the operation to the magnetoresistive element if the resistance state of the magnetoresistive element read by the read unit is identical to the target resistance state of the magnetoresistive element.
(4) The storage device according to (2) or (3), further comprising:
   a write voltage generation unit configured to output a voltage contributing to the voltage to be output by the voltage application unit to the voltage application unit depending on the target resistance state of the magnetoresistive element.
(5) The storage device according to (4), wherein
   the write voltage generation unit outputs an off voltage or an on voltage to the voltage application unit depending on a write select voltage indicating whether the operation is to be performed or not.
(6) The storage device according to (5), wherein
   the write voltage generation unit, in the case where the write select voltage is a voltage indicating that the operation is not to be performed, outputs the off voltage or the on voltage to the voltage application unit, independent of the target resistance state of the magnetoresistive element.
(7) The storage device according to any one of (2) to (6), further comprising:
   a comparison unit configured to perform a comparison to determine whether the resistance state of the magnetoresistive element read by the read unit is identical to or different from the target resistance state of the magnetoresistive element.
(8) The storage device according to (7), further comprising:
   a feedback unit configured to determine whether to continue or stop the operation depending on a comparison result obtained by the comparison unit.
(9) The storage device according to (8), further comprising:
   a write selection unit configured to select whether to continue or stop the operation depending on a determination result obtained by the feedback unit, wherein
   the voltage application unit continues or stops the operation depending on a selection result obtained by the write selection unit.
(10) The storage device according to any one of (1) to (9), wherein
   the read unit includes two inverters with different threshold voltages.
(11) The storage device according to any one of (1) to (10), further comprising:
   a reference voltage generation unit configured to supply a reference voltage to the read unit.
(12) The storage device according to (11), wherein
   the reference voltage generation unit includes a plurality of reference resistors or a single reference resistor.
(13) The storage device according to (12), wherein
   at least one of the plurality of reference resistors or the single reference resistor includes a plurality of magnetoresistive elements.
(14) The storage device according to any one of (1) to (13), wherein
   the voltage application unit includes a plurality of magnetoresistive elements that each function as a load resistor.
(15) The storage device according to (14), wherein
   at least two of the plurality of magnetoresistive elements are elements with different areas from each other.
(16) The storage device according to any one of (1) to (15), wherein
   the read unit includes a plurality of magnetoresistive elements that each function as a load resistor.
(17) The storage device according to (16), wherein
   at least two of the plurality of magnetoresistive elements are elements with different areas from each other.
(18) The storage device according to any one of (1) to (17), wherein
   the selection element includes a drain terminal, a source terminal, and a gate terminal,
   one of two terminals of the magnetoresistive element is connected to a bit line, which is the control line, and the other terminal is connected to the drain terminal,
   the source terminal is connected to a source line, and
   the gate terminal is connected to a word line.
(19) An electronic apparatus comprising:
   a storage device configured to store data, wherein
   the storage device includes:
      a magnetoresistive element with a resistance state changing upon application of a voltage;
      a selection element connected to the magnetoresistive element;
      a control line connected to a side of the magnetoresistive element opposite to a side connected to the selection element;
      a voltage application unit connected to the control line to output a voltage to the magnetoresistive element; and
      a read unit connected to the control line to read the resistance state of the magnetoresistive element,
      the read unit reads the resistance state of the magnetoresistive element during an operation in which the voltage application unit outputs the voltage to the magnetoresistive element, and
      the voltage application unit controls the operation depending on the resistance state of the magnetoresistive element read by the read unit.
(20) A method of controlling a storage device, the method comprising:
   outputting a voltage to a magnetoresistive element by a voltage application unit connected to a control line, in a memory cell including the magnetoresistive element with a resistance state changing upon application of a voltage and a selection element connected to the magnetoresistive element, the control line being connected to a side of the magnetoresistive element opposite to a side connected to the selection element; and
   reading the resistance state of the magnetoresistive element by a read unit connected to the control line, wherein
   the read unit reads the resistance state of the magnetoresistive element during an operation in which the voltage application unit outputs the voltage to the magnetoresistive element, and
   the voltage application unit controls the operation depending on the resistance state of the magnetoresistive element read by the read unit.
(21) A storage device including:
   a memory cell having a magnetoresistive element that can be changed between a first state and a second state upon application of a voltage and a selection element connected to the magnetoresistive element;
   a voltage application unit connected to a bit line connected to the memory cell and configured to output to the magnetoresistive element a first voltage that sets the magnetoresistive element to the first state or a second voltage that sets the magnetoresistive element to the second state depending on write data that specifies that the magnetoresistive element is in the first state or the second state; and
   a read unit connected to the bit line and configured to read whether the magnetoresistive element is in the first state or the second state to output the result as read data, in which
   the read unit reads whether the magnetoresistive element is in the first state or the second state at least during a write operation in which the voltage application unit outputs the first voltage or the second voltage, and outputs the result as read data, and
   the voltage application unit continues the write operation if the write data and the read data are different during the write operation and stops the write operation if the write data and the read data are the same.
(22) The storage device according to (21), in which
   the voltage application unit outputs a third voltage, different from the first voltage and the second voltage, to the magnetoresistive element to stop the write operation in the case where the write data and the read data are the same.
(23) The storage device according to (21) or (22), further including
   a write voltage generation unit that outputs a voltage that contributes to the first voltage or the second voltage to the voltage application unit depending on the write data.
(24) The storage device according to (23), in which
   the write voltage generation unit outputs an off voltage or an on voltage to the voltage application unit depending on a write selection voltage indicating whether the write operation is to be performed or not.
(25) The storage device according to (24), in which
   the write voltage generation unit outputs the off voltage or the on voltage to the voltage application unit independent of the write data in the case where the write selection voltage is a voltage indicating that the write operation is not to be performed.
(26) The storage device according to any one of (21) to (25), further including
   a comparison unit that performs a comparison to determine whether the write data and the read data are the same or different.
(27) The storage device according to (26), further including
   a feedback unit that determines whether to continue or stop the write operation depending on the comparison result obtained by the comparison unit.
(28) The storage device according to (27), further including
   a write selection unit that selects whether to continue or stop the write operation depending on the determination result obtained by the feedback unit, in which
   the voltage application unit continues or stops the write operation depending on the selection result of the write selection unit.
(29) The storage device according to any one of (1) to (28), in which
   the read unit has two inverters with different threshold voltages.
(30) The storage device according to any one of (21) to (29), further including
   a reference voltage generation unit that supplies a reference voltage to the read unit.
(31) The storage device according to (30), in which
   the reference voltage generation unit has a plurality of reference resistors or a single reference resistor.
(32) The storage device according to (31), in which
   at least one of the plurality of reference resistors or the single reference resistor includes a plurality of magnetoresistive elements.
(33) The storage device according to any one of (21) to (32), in which
   the voltage application unit has a plurality of magnetoresistive elements that each function as a load resistor.
(34) The storage device according to (33), in which
   at least two of the plurality of magnetoresistive elements are elements with different areas from each other.
(35) The storage device according to any one of (21) to (34), in which
   the read unit has a plurality of magnetoresistive elements that each function as a load resistor.
(36) The storage device according to (35), in which
   at least two of the plurality of magnetoresistive elements are elements with different areas from each other.
(37) The storage device according to any one of (21) to (36), in which
   the selection element has a drain terminal, a source terminal, and a gate terminal,
   one of two terminals of the magnetoresistive element is connected to the bit line, and the other terminal is connected to the drain terminal,
   the source terminal is connected to a source line, and
   the gate terminal is connected to a word line.
(38) The storage device according to any one of (21) to (36), in which
   the selection element has a drain terminal, a source terminal, and a gate terminal,
   one of two terminals of the magnetoresistive element is connected to the source line, and the other terminal is connected to the source terminal,
   the drain terminal is connected to a bit line, and
   the gate terminal is connected to a word line.
(39) An electronic apparatus including
   a storage device that stores data,
   the storage device including:
      a memory cell having a magnetoresistive element that can be changed between a first state and a second state upon application of a voltage and a selection element connected to the magnetoresistive element;
      a voltage application unit connected to a bit line connected to the memory cell and configured to output to the magnetoresistive element a first voltage that sets the magnetoresistive element to the first state or a second voltage that sets the magnetoresistive element to the second state, depending on write data that specifies that the magnetoresistive element is in the first state or the second state; and
      a read unit connected to the bit line and configured to read whether the magnetoresistive element is in the first state or the second state and output the result as read data, in which
      the read unit reads whether the magnetoresistive element is in the first state or the second state at least during a write operation in which the voltage application unit outputs the first voltage or the second voltage, and outputs the result as read data, and
      the voltage application unit continues the write operation if the write data and the read data are different during the write operation and stops the write operation if the write data and the read data are the same.
(40) A method of controlling a storage device, including:
   outputting, by a voltage application unit connected to a bit line connected to a memory cell having a magnetoresistive element that can be changed between a first state and a second state upon application of a voltage and a selection element connected to the magnetoresistive element, a first voltage that sets the magnetoresistive element to the first state or the second voltage that sets the magnetoresistive element to the second state, to the magnetoresistive element, depending on write data that specifies that the magnetoresistive element is in the first state or the second state; and
   reading, by a read unit connected to the bit line, whether the magnetoresistive element is in the first state or the second state and outputting the result as read data, in which
   the read unit reads whether the magnetoresistive element is in the first state or the second state at least during a write operation in which the voltage application unit outputs the first voltage or the second voltage, and outputs the result as read data, and
   the voltage application unit continues the write operation if the write data and the read data are different during the write operation, and stops the write operation if the write data and the read data are the same.
(41) An electronic apparatus including the storage device according to any one of (1) to (18) or (21) to (38).
(42) A method of controlling a storage device, in which the storage device is according to any one of (1) to (18) or (21) to (38).

### Reference Signs List

- 1: MEMORY SYSTEM
- 2: INTERFACE UNIT
- 3: MEMORY CONTROL UNIT
- 4: MEMORY ARRAY
- 10: MEMORY CELL ARRAY
- 11: WORD LINE
- 12: BIT LINE
- 13: SOURCE LINE
- 14: WRITE SELECTION LINE
- 15: STATE-0 WRITE VOLTAGE LINE
- 16: STATE-1 WRITE VOLTAGE LINE
- 17: WRITE DATA LINE
- 18: WRITE START SIGNAL LINE
- 19: WRITE SIGNAL LINE
- 20: BIT LINE ADDRESS DECODER
- 30: WORD LINE ADDRESS DECODER
- 40: WRITE CONTROL UNIT
- 50: WRITE UNIT
- 51: WRITE VOLTAGE GENERATION UNIT
- 52: VOLTAGE APPLICATION UNIT
- 53: READ UNIT
- 54: COMPARISON UNIT
- 55: FEEDBACK UNIT
- 56: WRITE SELECTION UNIT
- 60: SENSE AMPLIFIER
- 70: COLUMN SWITCH
- 100: MEMORY CELL
- 101: WIRING
- 102: WIRING
- 103: CONTACT LAYER
- 104: CONTACT LAYER
- 110: SELECTION ELEMENT
- 120: MAGNETORESISTIVE ELEMENT
- 121: BASE LAYER
- 122: MAGNETIZATION PINNED LAYER
- 123: TUNNEL BARRIER LAYER
- 124: STORAGE LAYER
- 125: CAP LAYER
- 300: IMAGING DEVICE
- 307: MEMORY
- 400: DISTANCE MEASUREMENT DEVICE
- 407: MEMORY
- 900: GAME DEVICE
- 920: MEMORY UNIT

## Claims

1. A storage device comprising:
a magnetoresistive element with a resistance state changing upon application of a voltage;
a selection element connected to the magnetoresistive element;
a control line connected to a side of the magnetoresistive element opposite to a side connected to the selection element;
a voltage application unit connected to the control line to output a voltage to the magnetoresistive element; and
a read unit connected to the control line to read the resistance state of the magnetoresistive element, wherein
the read unit reads the resistance state of the magnetoresistive element during an operation in which the voltage application unit outputs the voltage to the magnetoresistive element, and
the voltage application unit controls the operation depending on the resistance state of the magnetoresistive element read by the read unit.

2. The storage device according to claim 1, wherein
the voltage application unit continues the operation if the resistance state of the magnetoresistive element read by the read unit differs from a target resistance state of the magnetoresistive element, and stops the operation if the resistance state of the magnetoresistive element read by the read unit is identical to the target resistance state of the magnetoresistive element.

3. The storage device according to claim 2, wherein
the voltage application unit outputs a voltage used for stopping the operation to the magnetoresistive element if the resistance state of the magnetoresistive element read by the read unit is identical to the target resistance state of the magnetoresistive element.

4. The storage device according to claim 2, further comprising:
a write voltage generation unit configured to output a voltage contributing to the voltage to be output by the voltage application unit to the voltage application unit depending on the target resistance state of the magnetoresistive element.

5. The storage device according to claim 4, wherein
the write voltage generation unit outputs an off voltage or an on voltage to the voltage application unit depending on a write select voltage indicating whether the operation is to be performed or not.

6. The storage device according to claim 5, wherein
the write voltage generation unit, in the case where the write select voltage is a voltage indicating that the operation is not to be performed, outputs the off voltage or the on voltage to the voltage application unit, independent of the target resistance state of the magnetoresistive element.

7. The storage device according to claim 2, further comprising:
a comparison unit configured to perform a comparison to determine whether the resistance state of the magnetoresistive element read by the read unit is identical to or different from the target resistance state of the magnetoresistive element.

8. The storage device according to claim 7, further comprising:
a feedback unit configured to determine whether to continue or stop the operation depending on a comparison result obtained by the comparison unit.

9. The storage device according to claim 8, further comprising:
a write selection unit configured to select whether to continue or stop the operation depending on a determination result obtained by the feedback unit, wherein
the voltage application unit continues or stops the operation depending on a selection result obtained by the write selection unit.

10. The storage device according to claim 1, wherein
the read unit includes two inverters with different threshold voltages.

11. The storage device according to claim 1, further comprising:
a reference voltage generation unit configured to supply a reference voltage to the read unit.

12. The storage device according to claim 11, wherein
the reference voltage generation unit includes a plurality of reference resistors or a single reference resistor.

13. The storage device according to claim 12, wherein
at least one of the plurality of reference resistors or the single reference resistor includes a plurality of magnetoresistive elements.

14. The storage device according to claim 1, wherein
the voltage application unit includes a plurality of magnetoresistive elements that each function as a load resistor.

15. The storage device according to claim 14, wherein
at least two of the plurality of magnetoresistive elements are elements with different areas from each other.

16. The storage device according to claim 1, wherein
the read unit includes a plurality of magnetoresistive elements that each function as a load resistor.

17. The storage device according to claim 16, wherein
at least two of the plurality of magnetoresistive elements are elements with different areas from each other.

18. The storage device according to claim 1, wherein
the selection element includes a drain terminal, a source terminal, and a gate terminal,
one of two terminals of the magnetoresistive element is connected to a bit line, which is the control line, and the other terminal is connected to the drain terminal,
the source terminal is connected to a source line, and
the gate terminal is connected to a word line.

19. An electronic apparatus comprising:
a storage device configured to store data, wherein
the storage device includes:
a magnetoresistive element with a resistance state changing upon application of a voltage;
a selection element connected to the magnetoresistive element;
a control line connected to a side of the magnetoresistive element opposite to a side connected to the selection element;
a voltage application unit connected to the control line to output a voltage to the magnetoresistive element; and
a read unit connected to the control line to read the resistance state of the magnetoresistive element,
the read unit reads the resistance state of the magnetoresistive element during an operation in which the voltage application unit outputs the voltage to the magnetoresistive element, and
the voltage application unit controls the operation depending on the resistance state of the magnetoresistive element read by the read unit.

20. A method of controlling a storage device, the method comprising:
outputting a voltage to a magnetoresistive element by a voltage application unit connected to a control line, in a memory cell including the magnetoresistive element with a resistance state changing upon application of a voltage and a selection element connected to the magnetoresistive element, the control line being connected to a side of the magnetoresistive element opposite to a side connected to the selection element; and
reading the resistance state of the magnetoresistive element by a read unit connected to the control line, wherein
the read unit reads the resistance state of the magnetoresistive element during an operation in which the voltage application unit outputs the voltage to the magnetoresistive element, and
the voltage application unit controls the operation depending on the resistance state of the magnetoresistive element read by the read unit.
